(19) Europäisches Patentamt
European Patent Office
Office européen des brevets

(11) **EP 1 798 858 B1**

(12) **EUROPÄISCHE PATENTSCHRIFT**

(45) Veröffentlichungstag und Bekanntmachung des Hinweises auf die Patenterteilung:
**24.06.2009   Patentblatt 2009/26**

(51) Int Cl.:
*H03L 7/081* (2006.01)      *H03L 7/197* (2006.01)

(21) Anmeldenummer: **06025400.0**

(22) Anmeldetag: **08.12.2006**

(54) **PLL-Frequenzgenerator**

PLL frequency generator

Générateur de fréquence avec boucle de phase

(84) Benannte Vertragsstaaten:
**DE FR GB**

(30) Priorität: **17.12.2005   DE 102005060470**

(43) Veröffentlichungstag der Anmeldung:
**20.06.2007   Patentblatt 2007/25**

(73) Patentinhaber: **ATMEL Germany GmbH**
**74072 Heilbronn (DE)**

(72) Erfinder:
• **Beyer, Sascha**
**01458 Ottendorf-Okrilla (DE)**

• **Jaehne, Rolf**
**01458 Ottendorf-Okrilla (DE)**

(74) Vertreter: **Koch, Bertram**
**Koch Müller**
**Patentanwaltsgesellschaft mbH**
**Maaßstraße 32/1**
**69123 Heidelberg (DE)**

(56) Entgegenhaltungen:
**EP-A- 1 434 352**          **WO-A-86/07219**
**WO-A-20/04088846**

**Beschreibung**

Die vorliegende Erfindung betrifft einen PLL-Frequenzgenerator (phase locked loop) nach dem Oberbegriff des Patentanspruchs 1. Die Erfindung betrifft weiterhin eine Sende-/Empfangsvorrichtung und eine integrierte Schaltung mit einem solchen PLL-Frequenzgenerator.

Die Erfindung liegt auf dem Gebiet der Telekommunikation. Sie liegt insbesondere auf dem Gebiet von PLL-Frequenzgeneratoren, mit deren Hilfe Sende-/ Empfangsvorrichtungen in Telekommunikationssystemen auf spektral beabstandete Trägerfrequenzkanäle zugreifen. Solche PLL-Frequenzgeneratoren leiten aus einem hochpräzisen Referenzsignal ein Ausgangssignal mit einer einstellbaren Zielfrequenz ab und stellen es als lokales Oszillatorsignal zur empfängerseitigen Herabmischung des Empfangssignals und/oder zur senderseitigen Heraufmischung bereit. Die einstellbare Zielfrequenz ist hierbei aus einer Gruppe vorgegebener Zielfrequenzwerte, dem sog. Frequenzraster, wählbar.

Entsprechen die Zielfrequenzwerte jeweils einem ganzzahligen Vielfachen der Frequenz des Referenzsignals ("Referenzfrequenz"), kann die Frequenz des Ausgangssignals im Rückkopplungszweig des Frequenzgenerators durch einen ganzzahligen Teiler geteilt werden. Aufgrund von Phasenrauschen weist das Spektrum des Ausgangssignals eines solchen "integer-N" PLL-Frequenzgenerators neben der gewünschten Spektrallinie bei der Zielfrequenz einen umgebenden Störanteil auf, der das Signal/Rausch-Verhältnis des Ausgangssignals bestimmt.

Ist jedoch z.B. der minimale Abstand zwischen zwei benachbarten Zielfrequenzwerten kleiner als die Referenzfrequenz, so wird im Rückkopplungszweig des Frequenzgenerators eine Frequenzteilung durch einen nichtganzzahligen Teiler erforderlich. Derartige Frequenzteilungen werden üblicherweise durch schaltbare Frequenzteiler (multi modulus divider, MMD) bewerkstelligt, die jeweils zeitweise Frequenzteilungen durch unterschiedliche ganzzahlige Teilerwerte vornehmen, um im zeitlichen Mittel die erforderliche nichtganzzahlige Frequenzteilung zu erreichen. Die Umschaltung zwischen unterschiedlichen ganzzahligen Teilerwerten verursacht jedoch einen zusätzlichen, zeitvarianten periodischen Phasenfehler im frequenzgeteilten Signal und damit im Spektrum des Ausgangssignals einen weiteren Störanteil in Form von Spektrallinien. Ohne weitere Maßnahmen zur Kompensation des zusätzlichen Phasenfehlers weist das Ausgangssignal eines solchen "fractional-N" PLL-Frequenzgenerators daher ein niedrigeres Signal/Rausch-Verhältnis auf als ein entsprechender integer-N PLL-Frequenzgenerator bzw. ein im Integer-Modus betriebener fractional-N PLL-Frequenzgenerator.

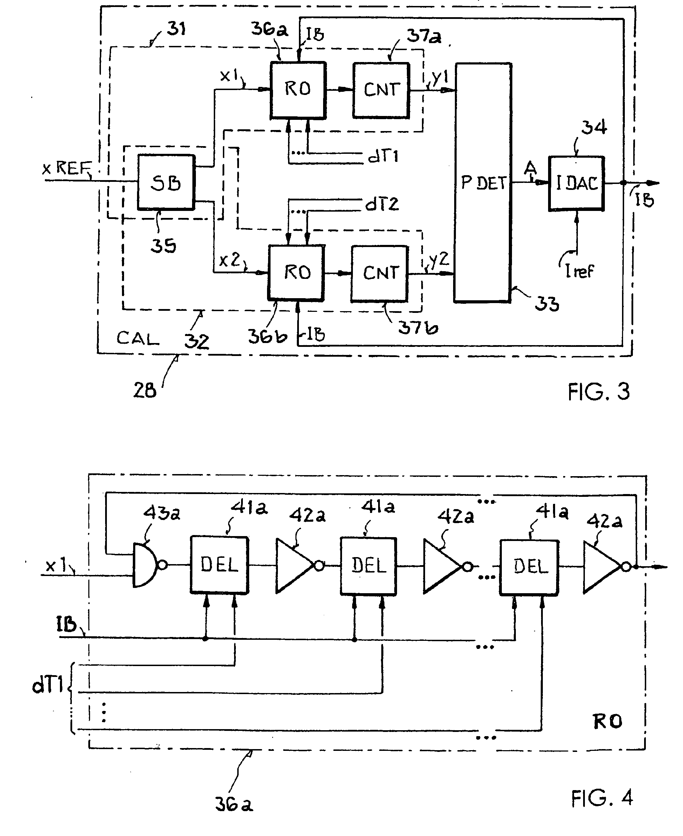

Aus der Patentschrift US 6,064,272 ist ein fractional-N PLL-Frequenzgenerator bekannt, der im Rückkopplungszweig eine dem schaltbaren Frequenzteiler nachgeschaltete Phasenkompensationsschaltung aufweist. Diese Phasenkompensationsschaltung stellt mit Hilfe von unterschiedlich viele Verzögerungselemente enthaltenden Verzögerungsleitungen Insgesamt vier unterschiedlich verzögerte Varianten des frequenzgetellten Signals bereit, aus denen eines durch eine Kontrollschaltung ausgewählt wird. Weiterhin ist eine Abstimmschaltung ("on-chip tuning circuit") mit vier bzw. 16 Verzögerungselementen vorgesehen, die eine Steuerspannung für die Verzögerungselemente erzeugt. Die Steuerspannung wird hierbei aus dem VCO-Ausgangssignal (Fig. 3), aus einem fest, d.h. unveränderlich frequenzgetellten Signal (Fig. 5) oder aber aus zwei zueinander phasenverschobenen Varianten des fest frequenzgeteilten Signals (Fig. 6) abgeleitet. Zur Abstimmung der Verzögerungselemente ist eine *Regelung* vorgesehen, die auf dem VCO-Ausgangssignal basiert, das von der PLL eingestellt wird.

Nachteilig ist hierbei, daß der Realisierungsaufwand und der Energieverbrauch der Phasenkompensationsschaltung und der Abstimmschaltung bei höheren Frequenzauflösungen (Abstand zwischen zwei benachbarten Zielfrequenzwerten deutlich kleiner als Referenzfrequenz) und/oder bei höheren Zielfrequenzwerten beispielsweise im GHz-Bereich drastisch ansteigt und eine Implementierung des Frequenzgenerators daher unökonomisch bzw. praktisch nicht mehr möglich ist. Nachteilig ist weiterhin, daß die Abstimmschaltung kontinuierlich im Betrieb gehalten werden muß, was einen zusätzlichen Energieverbrauch des Frequenzgenerators zur Folge hat.

Aus der EP-A-1 434 352 ist ein durch Verzögerung fehlerkompensierter fractional-N Frequenzgenerator, welcher auf einem Phase-Locked Loop PLL basiert, der einen Phasenfrequenzdetektor (PFD), eine Ladungspumpe, einen Haupt-Schleifenfilter, einen spannungsgesteuerten Oszillator und einen Frequenzteiler aufweist, die in Serie geschalten sind. Ferner ist eine Kalibrierungsschleife, welche mit dem PFD gekoppelt ist, und die eine weitere Ladungspumpe sowie einen weiteren Schleifenfilter für die Kalibrierung aufweist, sowie eine steuersignalgesteuerte Steuerlogik zur Steuerung des Frequenzteilers enthalten, wobei ein Referenzfrequenz-Signal sowohl an den PFD als auch an die Steuerlogik geführt wird. Ein Kalibrierungssignal wird der Kalibrierungsschleife zugeführt. Der Haupt-Schleifenfliter weist ferner eine Verzögerungseinrichtung auf, die durch die Steuerlogik gesteuert wird und Korrektursignale von der Kalibrierungsschleife erhält.

Aus der WO 2004/088846 A ist ein ebenfalls ein fractional-N PLL Frequenzgenerator offenbart, bei welchem mit Hilfe einer Verzögerungseinheit eine Kompensation erzielt wird, die allein von einem von einer Steuereinheit erzeugten Steuersignal gesteuert wird.

Der Erfindung liegt die Aufgabe zugrunde, einen PLL-Frequenzgenerator anzugeben, der insbesondere bei höheren Frequenzauflösungen und/oder höheren Zielfrequenzwerten möglichst einfach zu implementieren und möglichst energiesparend zu betreiben ist.

Erfindungsgemäß wird diese Aufgabe gelöst durch einen PLL-Frequenzgenerator, eine Sende-/Empfangsvorrichtung und eine integrierte Schaltung mit den Merkmalen der Patentansprüche 1, 22 bzw. 23.

Der erfindungsgemäße PLL-Frequenzgenerator zum Generieren eines Ausgangssignals mit einer einstellbaren Zielfrequenz weist folgende Einheiten auf: a) einen spannungsgesteuerten Oszillator zum Generieren des Ausgangssignals in Abhängigkeit von einer Steuerspannung, b) einen mit dem spannungsgesteuerten Oszillator verbundenen schaltbaren Frequenzteiler, der ausgebildet ist, aus dem Ausgangssignal ein frequenzgeteiltes Signal abzuleiten, dessen Momentanfrequenz von einem Wert eines einstellbaren Teilers abhängt, c) eine mit dem Frequenzteiler verbundene schaltbare Verzögerungseinheit, die ausgebildet ist, ein verzögertes Signal zu bilden, indem das frequenzgeteilte Signal um Verzögerungszeiten verzögert wird, die jeweils von einem Steuerwort und einem Steuersignal abhängen, d) einen mit der schaltbaren Verzögerungseinheit verbundenen Phasendetektor, der ausgebildet ist, die Phasendifferenz zwischen einem Referenzsignal und dem verzögerten Signal zu bestimmen und zur Bildung der Steuerspannung bereitzustellen, und e) eine mit der schaltbaren Verzögerungseinheit verbundene Kalibrierungseinheit, die ausgebildet ist, das Steuersignal aus dem Referenzsignal abzuleiten.

Die erfindungsgemäße Sende-/Empfangsvorrichtung und die erfindungsgemäße integrierte Schaltung weisen jeweils einen solchen PLL-Frequenzgenerator auf.

Das Wesen der Erfindung besteht darin, eine Kalibrierungseinheit vorzusehen, die das Steuersignal zur Kalibrierung der schaltbaren Verzögerungseinheit aus dem Referenzsignal ableitet. Anstelle einer *Regelung* basierend auf dem VCO-Ausgangssignal erfolgt erfindungsgemäß also eine *Kalibrierung* auf der Basis des hochpräzisen Referenzsignals. Hierdurch kann der durch die fractionat-N-Teilung verursachte zusätzliche Phasenfehler auch bei höheren Frequenzauflösungen und/oder höheren Zielfrequenzwerten aufwandsgünstig und betriebsenergiesparend momentan kompensiert werden, selbst wenn Betriebsspannungsschwankungen, Temperatureinflüsse, Parameterschwankungen etc. vorliegen. Der nachgeschaltete Phasendetektor "sieht" daher nur noch den verbleibenden "integer-N" Phasenfehler, so daß sich mit Hilfe der Erfindung die Vorteile von integer-N Frequenzgeneratoren (geringer Phasenjitter, hohes Signal/Rausch-Verhältnis) mit denjenigen von fractional-N Frequenzgeneratoren (hohe Frequenzauflösung) verbinden lassen. Leistungsfähige integrierte Schaltungen und damit auch leistungsfähige Sende/Empfangsvorrichtungen können deshalb einfach, kostengünstig und energieeffizient realisiert werden.

Weiterhin kann die Kalibrierung vorteilhaft auch dann erfolgen, wenn die PLL-Regelschleife (noch) nicht eingeschwungen ist, z.B. beim Aktivieren des PLL-Frequenzgenerators. Außerdem ist kein kontinuierlicher Betrieb der kalibrierungseinheit, sondern lediglich ein sich z.B. periodisch wiederholender kurzzeitiger Betrieb erforderlich, so daß der erfindungsgemäße PLL-Frequenzgenerator besonders energiesparend betrieben werden kann.

Vorteilhafte Ausgestaltungen und Weiterbildungen der Erfindung sind den abhängigen Ansprüchen sowie der Beschreibung unter Bezugnahme auf die Zeichnung zu entnehmen.

In einer bevorzugten Ausführungsform leitet die kalibrierungseinheit aus dem Referenzsignal zwei Gesamtverzögerungszeiten ab und stellt das Steuersignal so ein, dass sich diese Gesamtverzögerungszeiten um ein vorgegebenes Zeitintervall unterscheiden.

Vorzugsweise leitet die Kalibrierungseinheit zwei Signale mit zwei Flanken aus dem Referenzsignal ab und stellt das Steuersignal so ein, dass ein vorgegebenes Zeitintervall zwischen den Flanken liegt. Dies ermöglicht vorteilhaft einfache und energiesparende Realisierungen.

Das vorgegebene Zeitintervall ist hierbei bevorzugt aus der Periodendauer des Referenzsignals abgeleitet, wobei es vorzugsweise der Periodendauer des Referenzsignals oder einem Vielfachen der Periodendauer des Referenzsignals entspricht.

In einer weiteren bevorzugten Ausführungsform weist die Kalibrierungseinheit zur Bildung einer vom Steuersignal abhängigen ersten Gesamtverzögerungszeit einen durch das Steuersignal gesteuerten ersten (Signal)Pfad und zur Bildung einer vom Steuersignal abhängigen zweiten Gesamtverzögerungszeit einen durch das Steuersignal gesteuerten zweiten (Signal)Pfad auf und ist ausgebildet, das Steuersignal so einzustellen, daß sich die erste von der zweiten Gesamtverzögerungszeit um einen vorgegebenen nichtverschwindenden Wert eines ganzzahligen Vielfachen K der Periodendauer des Referenzsignals unterscheidet. Auf diese Weise kann die Kalibrierungseinheit sehr einfach realisiert und sehr energiesparend betrieben werden. Wird hierbei K = 1 gewählt, so sind vorteilhaft besonders einfache und energiesparende Implementierungen möglich.

In einer besonders vorteilhaften Ausführungsform weist der erste Pfad zur Bildung der ersten Gesamtverzögerungszeit einen durch das Steuersignal gesteuerten ersten Ringoszillator und der zweite Pfad zur Bildung der zweiten Gesamtverzögerungszeit einen durch das Steuersignal gesteuerten zweiten Ringoszillator auf, wobei der erste und der zweite Pfad derart ausgestaltet sind, daß sich die erste Gesamtverzögerungszeit von der zweiten Gesamtverzögerungszeit um den vorgegebenen nichtverschwindenden wert des ganzzahligen Vielfachen K der Periodendauer unterscheidet, wenn das Steuersignal eingestellt ist. Hierdurch können die Gesamtverzögerungszeiten vorteilhaft mit sehr geringem Aufwand an Hardware und Betriebsenergie bereitgestellt werden. Vorzugsweise sind die beiden Ringoszillatoren im Wesentlichen identisch ausgestaltet.

In zwei weiteren besonders vorteilhaften Ausführungsformen weist a) der erste Ringoszillator bzw. der erste Pfad zur Bildung der ersten Gesamtverzögerungszeit mindestens eine durch das Steuersignal gesteuerte erste Verzögerungseinheit auf, die ausgebildet ist, ein an ihrem Eingang anliegendes Signal um eine vom Steuersignal abhängige erste Zeitspanne zu verzögern, die derjenigen nichtverschwindenden Verzögerungszeit entspricht, die die schaltbare Verzögerungseinheit hervorruft, wenn das Steuerwort einen ersten Wert annimmt, und b) der zweite Ringoszillator bzw. der zweite Pfad zur Bildung der zweiten Gesamtverzögerungszeit mindestens eine durch das Steuersignal gesteuerte zweite Verzögerungseinheit auf, die ausgebildet ist, ein an ihrem Eingang anliegendes Signal um eine vom Steuersignal abhängige zweite Zeitspanne zu verzögern, die derjenigen Verzögerungszeit entspricht, die die schaltbare Verzögerungseinheit hervorruft, wenn das Steuerwort einen zweiten Wert annimmt, wobei die zweite Zeitspanne länger als die erste Zeitspanne ist. Vorzugsweise sind die ersten und die zweiten Verzögerungseinheiten hierbei jeweils im wesentlichen identisch mit der schaltbaren Verzögerungseinheit ausgestaltet. Die ersten und die zweiten Werte sind vorzugsweise so gewählt, daß sich die erste von der zweiten Gesamtverzögerungszeit um den vorgegebenen nichtverschwindenden Wert des ganzzahligen Vielfachen K der Periodendauer unterscheidet, wenn das Steuersignal eingestellt ist. Hierdurch kann der Phasenfehler auch bei hohen Frequenzauflösungen und/oder Zielfrequenzwerten unabhängig von der max. Verzögerungszeit einer einzelnen Verzögerungseinheit effizient korrigiert werden.

Vorzugsweise ist das Steuersignal als Steuerstrom ausgebildet. Das analoge Steuersignal kann hierdurch störungsarm innerhalb einer integrierten Schaltung übertragen werden.

In einer weiteren sehr vorteilhaften Ausführungsform a) ist der erste Pfad ausgebildet, ein erstes Ausgangssignal mit einer ersten Flanke bereitzustellen, b) ist der zweite Pfad ausgebildet, ein zweites Ausgangssignal mit einer zweiten Flanke bereitzustellen, c) weist die Kalibrierungseinheit eine Phasendetektorschaltung auf, die ausgebildet ist, festzustellen, ob die erste Flanke der zweiten Flanke vor- oder nacheilt und ein Wort eines digitalen Signals zu erzeugen, dessen Wert einen in Anbetracht dieser Feststellung erforderlichen Wert des Steuersignals repräsentiert. Auf diese Weise kann die Kalibrierungseinheit sehr einfach realisiert und besonders energiesparend betrieben werden.

In einer besonders vorteilhaften Ausführungsform weist der PLL-Frequenzgenerator einen Kalibrierungsmodus auf und ist ausgebildet, die Kalibrierungseinheit nur dann mit Betriebsenergie zu versorgen, wenn der Kalibrierungsmodus aktiv ist. Hierdurch kann der mittlere Energieverbrauch der Kalibrierungseinheit und damit des Frequenzgenerators drastisch gesenkt werden.

In einer weiteren besonders vorteilhaften Ausführungsform ist eine mit der schaltbaren Verzögerungseinheit verbundene Steuereinheit vorgesehen, die einen Sigma-Delta-Modulator aufweist und ausgebildet ist, die Steuerworte in Abhängigkeit von mindestens einem vom Sigma-Delta-Modulator bereitgestellten Signal zu bestimmen. Mit Hilfe des Sigma-Delta-Modulators können die relativ nah an der Zielfrequenz liegenden Spektrallinien im Störanteil des Spektrums des Ausgangssignals sehr effektiv unterdrückt werden, so daß sich ein besonders hohes Signal/Rausch-Verhältnis ergibt. Außerdem ist diese Ausführungsform einfach zu implementieren und energiesparend zu betreiben.

In einer weiteren sehr vorteilhaften Ausführungsform weist der Sigma-Delta-Modulator einen Akkumulator auf, der zum Akkumulieren eines Eingangssignals des Sigma-Delta-Modulators und zum Bereitstellen eines akkumulierten Signals ausgebildet ist, und ist die Steuereinheit ausgebildet, die Steuerworte in Abhängigkeit vom akkumulierten Signal zu bestimmen. Auf diese Weise können die Steuerworte sehr einfach und energiesparend bestimmt werden.

In einer besonders vorteilhaften Ausführungsform weist der Sigma-Delta-Modulator eine Ordnung von zwei auf. Diese Ausführungsform weist eine hohe Leistungsfähigkeit bei einer sehr einfachen Implementierbarkeit und einem sehr niedrigen Energieverbrauch auf.

Die Erfindung wird nachfolgend anhand der in den schematischen Figuren der Zeichnung angegebenen Ausführungsbeispiele näher erläutert. Hierbei zeigen

Fig. 1 Beispiel eines "Wireless Personal Area Network" (WPAN) nach IEEE 802.15.4 mit erfindungsgemäßen Sende-/Empfangsvorrichtungen;

Fig. 2 Ausführungsbeispiele erfindungsgemäßer PLL-Frequenzgeneratoren;

Fig. 3 Kalibrierungseinheit eines ersten Ausführungsbeispiels, und

Fig. 4 Ringoszillator der Kalibrierungseinheit aus Figur 3.

In den Figuren sind gleiche und funktionsgleiche Elemente und Signale - sofern nicht anders angegeben - mit denselben Bezugszeichen versehen.

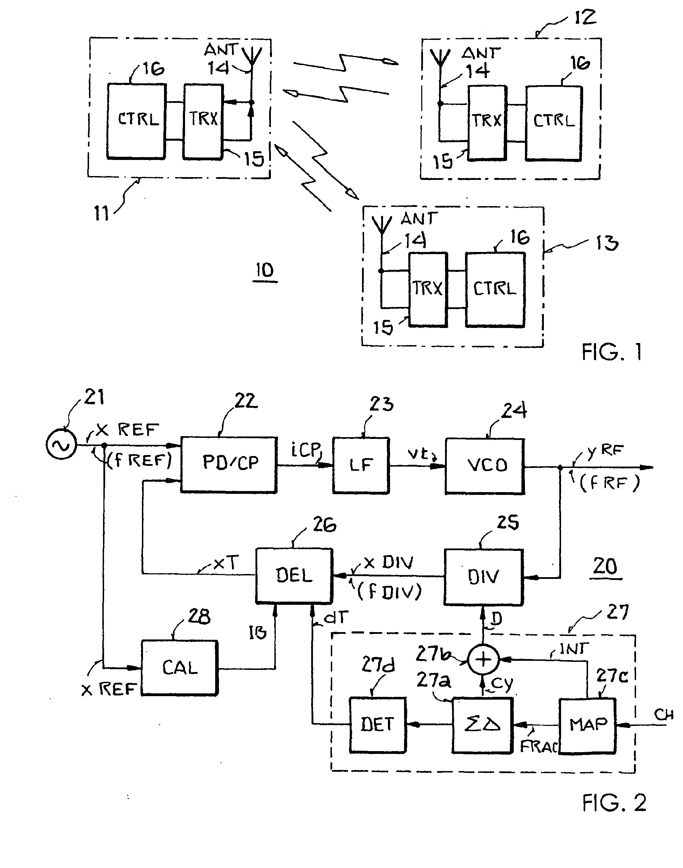

Zur drahtlosen Übertragung von Informationen über relativ kurze Distanzen können sog. "Wireless Personal Area Networks" (WPAN) verwendet werden. Fig. 1 zeigt ein Beispiel eines WPANs 10 nach dem Standard IEEE 802.15.4. Dieser Standard spezifiziert niederratige WPANs, die mit Rohdatenraten bis max. 250 kbit/s und ortsfesten oder mobilen Geräten für Anwendungen in der industriellen Überwachung und Steuerung, in Sensornetzwerken, in der Automatisierung sowie im Bereich der Computerperipherie und für interaktive Spiele geeignet sind. Neben einer sehr einfachen und kostengünstigen Implementierbarkeit der Geräte ist für derartige Anwendungen ein extrem geringer Energiebedarf der Geräte von entscheidender Bedeutung. So werden mit diesem Standard Batterielaufzeiten von mehreren Monaten bis zu mehreren Jahren angestrebt.

Das in Figur 1 dargestellte WPAN umfaßt drei Sende-/Empfangsvorrichtungen 11-13 in Form von ortsfesten oder mobilen Geräten, die mittels Funksignalen drahtlos Informationen austauschen. Bei der Sende-/Empfangsvorrichtung 11 handelt es sich um ein sog. Vollfunktionsgerät, das die Funktion des WPAN-Koordinators übernimmt, während es sich bei den Sende/Empfangsvor-richtungen 12, 13 um sog. Teilfunktionsgeräte handelt, die dem Vollfunktionsgerät 11 zugeordnet sind und nur mit diesem Daten austauschen können. Neben der in Fig. 1 dargestellten sternförmigen Netzwerktopologie, bei der die bidirektionale Datenübertragung nur zwischen jeweils einem der Teilfunktionsgeräte 12, 13 und dem Vollfunktionsgerät 11, nicht jedoch zwischen den Teilfunktionsgeräten 12, 13 erfolgen kann, sieht der Standard auch sog. "Peer-to-Peer"-Topologien vor, bei denen sämtliche Vollfunktionsgeräte mit jeweils allen anderen Vollfunktionsgeräten kommunizieren können.

Die Sende-/Empfangsvorrichtungen 11-13 umfassen jeweils eine Antenne 14, eine mit der Antenne verbundene Sende-/Empfangseinheit (transceiver, TRX) 15 zum Senden und Empfangen von Daten nach IEEE 802.15.4 und eine mit der Sende-/ Empfangseinheit verbundene Kontrolleinheit (control unit, CTRL) 16 zur Steuerung der Sende-/Empfangseinheit 15 gemäß IEEE 802.15.4. Weiterhin beinhalten die Sende-/Empfangsvorrichtungen 11-13 jeweils eine in Fig. 1 nicht dargestellte Energieversorgungseinheit in Form einer Batterie etc. zur Energieversorgung der Einheiten 15, 16, sowie evtl. weitere Komponenten (Sensoren, Aktoren etc.).

Im folgenden wird davon ausgegangen, daß die Datenübertragung im lizenzfreien ISM-Band (industrial, scientific, medical) bei 2,4 GHz erfolgt. In diesem Frequenzband sieht der IEEE-Standard 802.15.4 insgesamt 16 Kanäle im Abstand von jeweils 5 MHz vor. Für Rohdatenraten von fB=250 kbit/s ist in diesen Kanälen eine Bandspreizung (Spreading) mit einer Chiprate von fC=2 Mchip/s sowie eine Offset-QPSK-Modulation (quarternary phase shift keying) spezifiziert.

Die Sendeeinheit jeder Sende-/Empfangseinheit 15 wandelt den jeweils zu übertragenden Datenstrom in ein über ihre Antenne 14 abzustrahlendes Funksignal um, indem der zu sendende Datenstrom gemäß IEEE 802.15.4 zunächst in vier Bit breite Symbole und diese in aufeinanderfolgende PN-Sequenzen (pseudo noise) aus jeweils 32 Chips umgesetzt werden. Die Chips der aufeinanderfolgenden PN-Sequenzen werden anschließend Offset-QPSK-moduliert (quarternary phase shift keying), spektral mit Hilfe eines erfindungsgemäßen PLL-Frequenzgenerators in einen der 16 Kanäle im ISM-Frequenzband verschoben und schließlich für die Übertragung verstärkt. Da eine Offset-QPSK-Modulation mit Halbsinus-Impulsformung einer MSK-Modulation (minimum shift keying), d.h. einer FSK-Modulation (frequency shift keying) mit Modulationsindex 1/2 bzw. Frequenzhub $\Delta F=fC/4= 0,5$ MHz entspricht, kann der PLL-Frequenzgenerator im Rahmen einer direkten Frequenzmodulation auch den zusätzlichen Frequenzversatz durch das Modulationssignal berücksichtigen.

Die Empfangseinheit jeder Sende-/Empfangseinheit 15 wandelt ein von ihrer Antenne 14 empfangenes und von der Sendeeinheit einer anderen Sende-/Empfangsvorrichtung nach IE-EE 802.15.4 erzeugtes Funksignal möglichst fehlerfrei in die gesendeten Daten um, indem das empfangene Funksignal verstärkt, mit Hilfe des vorstehend genannten PLL-Frequenzgenerators spektral in das Basisband oder in einen Zwischenfrequenzbereich verschoben und dann demoduliert wird und schließlich die Daten detektiert werden.

Die Sende-/Empfangseinheit 15 ist hierbei jeweils Teil einer (in Figur 1 nicht dargestellten) integrierten Schaltung, z.B. eines ASICs (application specific integrated circuit) oder eines ASSPs (application specific standard product), während die Kontrolleinheit 16 jeweils durch einen (ebenfalls nicht dargestellten) Mikrocontroller realisiert ist. Vorteilhaft weist jede Sende-/Empfangsvorrichtung nur eine (z.B. als ASIC oder ASSP ausgeführte) integrierte Schaltung auf, die die Funktionen ihrer Sende-/Empfangseinheit 15 und ihrer Kontrolleinheit 16 wahrnimmt.

Figur 2 zeigt ein Blockschaltbild eines erfindungsgemäßen PLL-Frequenzgenerators für eine Sende-/Empfangseinheit 15 aus Figur 1. Der PLL-Frequenzgenerator 20 weist einen Referenzoszillator 21, einen Phasen(differenz)detektor/Ladungspumpe (phase detector/charge pump, PD/ CP) 22, ein Schleifenfilter (loop filter, LF) 23, einen spannungsgesteuerten Oszillator (voltage controlled oscillator, VCO) 24, einen schaltbaren Frequenzteiler (DIV) 25, eine schaltbare Verzögerungseinheit (DEL) 26, eine Steuereinheit 27 und eine Kalibrierungseinheit 28 auf.

Der Referenzoszillator 21 generiert ein ggf. verstärktes Referenzsignal xREF mit einer Referenzfrequenz fREF und ist z.B. als Quarzoszillator oder als spannungsgesteuerter Quarzoszillator ausgebildet.

Die PD/CP-Einheit 22 (Phasen(differenz)detektor/Ladungspumpe) weist einen mit dem Referenzoszillator 21 verbundenen ersten Eingang sowie einen mit dem Ausgang der Verzögerungseinheit 26 verbundenen zweiten Eingang auf. Die PD/CP-Einheit bestimmt die Phasenabweichung (Phasendifferenz) zwischen dem am ersten Eingang anliegenden Referenzsignal xREF und dem am zweiten Eingang anliegenden verzögerten Signal xT und stellt an ihrem Ausgang in Abhängigkeit von der Phasenabweichung einen definierten Strom iCP bereit. Anstelle des Phasendetektors kann auch ein Phasenfrequenzdetektor vorgesehen sein.

Das Schleifenfilter (LF) 23 weist einen mit der PD/CP-Einheit 22 verbundenen Eingang und einen mit dem VCO 24 verbundenen Ausgang auf. In Abhängigkeit von dem am Eingang anliegenden Strom iCP generiert das Schleifenfilter 23 eine Steuerspannung vt und stellt diese an seinem Ausgang bereit.

Der spannungsgesteuerte Oszillator (VCO) 24 weist einen mit dem Schleifenfilter 23 verbundenen Eingang und einen mit dem Frequenzteiler 25 verbundenen Ausgang auf. In Abhängigkeit von der am Eingang anliegenden Steuerspannung vt generiert der VCO 24 ein ggf. zusätzlich verstärktes Ausgangssignal yRF mit einer einstellbaren und z.B. von einem Kanalindex CH abhängigen Zielfrequenz fRF und stellt es an seinem Ausgang bereit.

Der schaltbare Frequenzteiler (DIV) 25 weist einen mit dem VCO 24 verbundenen Signaleingang sowie einen mit der Steuereinheit 27 verbundenen Steuereingang auf. Der Frequenzteiler 25 leitet aus dem an seinem Signaleingang anliegenden VCO-Ausgangssignal yRF ein frequenzgeteiltes Signal xDIV ab, dessen Momentanfrequenz fDIV nach fDIV=fRF/D vom aktuellen Wert des an seinem Steuereingang anliegenden einstellbaren Teilers D abhängt und stellt das frequenzgeteilte Signal xDIV an seinem Ausgang bereit.

Der Wert, den der Teiler annimmt, hängt von der einstellbaren Zielfrequenz fRF bzw. dem entsprechenden Kanalindex CH sowie von der Referenzfrequenz fREF des Referenzsignal xREF ab. Ist z.B. die Differenz zwischen den Zielfrequenzen zweier spektral benachbarter Kanäle, d.h. das Kanalraster, kleiner als die Referenzfrequenz fREF (man spricht in diesem Falle auch von einer "feinen" Frequenzauflösung), so nimmt der Teiler zumindest für manche Zielfrequenzen einen nichtganzzahligen Wert an. Im exemplarischen Falle einer Referenzfrequenz von fREF=16 MHz ergibt sich gemäß IEEE 802.15.4 für die niedrigste Zielfrequenz (fRF=2405 MHz) im ISM-Band beispielsweise der Teilerwert fRF/fREF = 150,3125.

Um derartige nichtganzzahlige Teilerwerte zu realisieren, ist der Frequenzteiler 25 schaltbar ausgeführt, wobei er jeweils zeitweise Frequenzteilungen mit unterschiedlichen ganzzahligen Teilerwerten D derart vornimmt, daß sich über ein gewisses Zeitintervall betrachtet "im Mittel" der erforderliche nichtganzzahlige Teilerwert ergibt. Frequenzgeneratoren mit einem solchen schaltbaren Frequenzteiler werden als fractional-N PLL-Frequenzgeneratoren bezeichnet.

Die Variation der Werte des Teilers D verursacht einen zeitvarianten Phasenfehler zwischen dem frequenzgeteilten Signal xDIV und dem Referenzsignal xREF, der das VCO-Ausgangssignal yRF über das Schleifenfilter 23 moduliert ("Störmodulation"). Zusätzlich zum Störanteil infolge von Phasenrauschen, der auch bei integer-N PLL-Frequenzgeneratoren vorhanden ist, weist das Spektrum des VCO-Ausgangssignals yRF bei fractional-N PLL-Frequenzgeneratoren infolge dieses zeitvarianten periodischen Phasenfehlers einen weiteren Störanteil in Form von Spektrallinien um die Zielfrequenz fRF auf, der vom nichtganzzahligen Anteil des im Mittel zu realisierenden nichtganzzahligen Teilerwertes abhängt. Erfindungsgemäß werden diese Spektrallinien weitgehend unterdrückt.

Vorzugsweise ist der Frequenzteiler 25 als sog. multi modulus divider (MMD), d.h. als digitaler, im Zählbereich programmierbarer Zähler, realisiert. Vorteilhaft besteht der MMD aus zwei Frequenzteilern, wobei der erste auch als Prescaler bezeichnet wird und ausgebildet ist, Frequenzteilungen durch N oder N+1 vorzunehmen und der zweite mit einem üblicherweise festen Teilerverhältnis arbeitet und den Moduluseingang des Prescalers in Abhängigkeit des am Steuereingang anliegenden Teilers D steuert.

Die schaltbare Verzögerungseinheit (DEL) 26 weist einen mit dem Frequenzteiler 25 verbundenen Signaleingang sowie einen mit der Kalibrierungseinheit 28 verbundenen ersten Steuereingang und einen mit der Steuereinheit 27 verbundenen zweiten Steuereingang auf. Die Verzögerungseinheit 26 bildet ein verzögertes Signal xT, indem das an ihrem Signaleingang anliegende frequenzgeteilte Signal xDIV um Verzögerungszeiten $\Delta T$ verzögert wird, die jeweils von einem an ihrem ersten Steuereingang anliegenden Steuersignal IB und von einem an ihrem zweiten Steuereingang anliegenden digitalen Steuerwort dT abhängen und stellt das verzögerte Signal xT an ihrem Ausgang bereit. Die Verzögerungszeit $\Delta T$ hängt hierbei wie folgt vom Steuersignal IB und vom Steuerwort dT ab:

$$\Delta T = A(IB) \cdot (t0 + dT \cdot ts) \qquad\qquad (1)$$

Hierbei bezeichnen t0 eine Grundverzögerung von z.B. ca. 1ns, ts die von der Frequenzauflösung abhängige Schrittweite der Verzögerung und A(IB) eine vom Steuersignal IB abhängige Funktion. Aus Gleichung (1) ist zu erkennen, daß die Verzögerungszeit $\Delta T$ im wesentlichen linear vom entsprechenden Steuerwort dT abhängt. Bei einer exemplarischen Breite der Steuerworte von 7 Bit ist es so möglich, mit jedem Steuerwort dT eine von insgesamt 128 unterschiedlichen Verzögerungszeiten $\Delta T$ einzustellen. Innerhalb der Verzögerungseinheit 26, die vorzugsweise auf der Basis eines CMOS-Buffers realisiert ist, wird das Steuerwort dT in *einen* Strom oder eine Spannung umgesetzt, der/die die entsprechende Verzögerungszeit $\Delta T$ bis auf einen IB-abhängigen Faktor A(IB) einstellt. Das Steuerwort dT und das Steuersignal IB bestimmen die Größe eines Entladestroms, der einen Kondensator am Ausgang des ersten Inverters des Buffers entlädt. Die Steuerworte dT und das Steuersignal IB werden von der Steuereinheit 27 bzw. der Kalibrierungseinheit 28 so bestimmt, daß die resultierenden Verzögerungszeiten $\Delta T$ geeignet sind, den oben erläuterten zeitvarianten Phasenfehler momentan zu kompensieren.

Die Steuereinheit 27 weist einen Eingang zum Zuführen eines die Zielfrequenz fRF bestimmenden Parameters wie z.B. eines Kanalindizes CH auf. In Abhängigkeit vom Kanalindex CH bestimmt die Steuereinheit 27 die Steuerworte dT und stellt sie an ihrem mit dem zweiten Steuereingang der Verzögerungseinheit 26 verbundenen ersten Ausgang bereit. Vorzugsweise bestimmt die Steuereinheit 27 außerdem die Werte des einstellbaren Teilers D in Abhängigkeit vom Kanalindex CH und stellt sie an ihrem mit dem Steuereingang des Frequenzteilers 25 verbundenen zweiten Ausgang bereit.

Die Steuereinheit 27 weist vorzugsweise einen Sigma-Delta-Modulator ($\Sigma\Delta$) 27a, einen Addierer 27b, eine Mapping-Einheit (MAP) 27c und eine Bestimmungseinheit (DET) 27d zum Bestimmen der Steuerworte dT auf. Der Mapping-Einheit 27c wird eingangsseitig der Kanalindex CH zugeführt. Ausgangsseitig ist die Mapping-Einheit mit dem Sigma-Delta-Modulator 27a und einem ersten Eingang des Addierers 27b verbunden. Eingangsseitig ist der Addierer 27b an seinem zweiten Eingang mit dem Sigma-Delta-Modulator 27a und ausgangsseitig über den zweiten Ausgang der Steuereinheit 27 mit dem Frequenzteiler 25 verbunden. Der Sigma-Delta-Modulator 27a ist eingangsseitig mit der Mapping-Einheit 27c und ausgangsseitig mit dem Addierer 27b sowie der dT-Bestimmungseinheit 27d verbunden. Die dT-Bestimmungseinheit 27d ist eingangsseitig mit dem Sigma-Delta-Modulator 27a und ausgangsseitig über den ersten Ausgang der Steuereinheit 27 mit der schaltbaren Verzögerungseinheit 26 verbunden.

Die Mapping-Einheit 27c leitet aus dem Kanalindex CH die Werte INT und FRAC ab. Die Werte INT und FRAC geben hierbei zusammen an, mit welchem Faktor die Referenzfrequenz fREF multipliziert werden muß, um die in Anbetracht des Kanalindizes CH gewünschte Zielfrequenz fRF zu erreichen. Die Werte INT und FRAC werden so bestimmt, daß die folgende Gleichung gilt:

$$(INT + FRAC/RES) * fREF = fRF \quad . \qquad\qquad (2)$$

Der Parameter RES bestimmt hierbei die Frequenzauflösung des Frequenzgenerators. Je höher der Wert des Parameters RES ist, umso höhere Frequenzauflösungen werden erzielt, d.h. umso feiner ist das Frequenzraster bzw. umso enger benachbart sind die einstellbaren Zielfrequenzen. Mit den exemplarischen Werten RES=32 und fREF=16 MHz sind z.B. Zielfrequenzen im Abstand von fREF/RES =0,5 MHz einstellbar, was im Vergleich zur Referenzfrequenz fREF einer hohen Frequenzauflösung entspricht. Der Parameter FRAC nimmt in diesem Fall einen Wert zwischen null und RES-1=31 an und kann daher durch ein 5 Bit breites Wort repräsentiert werden. Die Schrittweite ts der durch die Verzögerungseinheit 26 einzustellenden Verzögerungszeiten $\Delta T$ gemäß Gleichung (1) beträgt vorteilhaft ts=1 / (fRF*RES) $\approx$ 0,012 ns.

Wird der PLL-Frequenzgenerator 20 senderseitig zur direkten Frequenzmodulation verwendet, so wird der Mapping-Einheit 27c außerdem das Modulationssignal zugeführt (nicht in Fig. 2 dargestellt). In Abhängigkeit von den Werten des Modulationssignals ergeben sich nun ggf. veränderte Zielfrequenzwerte fRF und damit gemäß Gleichung (2) veränderte FRAC/INT-Werte. Damit hängen auch die Werte des Teilers D und der Steuerworte dT vom Modulationssignal ab. Im Falle der o.g. exemplarischen Werte und eines zweistufigen Modulationssignals mit einem Frequenzhub von $\Delta F$=0,5 MHz verändert sich im allg. nur der FRAC-Wert um $\pm 1$ in Abhängigkeit vom aktuellen Wert des Modulationssignals. Das Modulationssignal kann außerdem einem schaltbar ausgeführten Schleifenfilter zugeführt werden, um ein schnelleres Einschwingen zu erreichen.

Der Sigma-Delta-Modulator 27a, dem der FRAC-Wert zugeführt wird, ermittelt im einfachsten Falle eines Sigma-Delta-Modulators erster Ordnung (M=1) eine Folge cy von binären Werten (null und eins), deren relative Häufigkeit den Wert FRAC/RES widerspiegelt. Mit den o.g. exemplarischen Werten von RES und fREF führt beispielsweise der Wert FRAC=16, der gemäß Gleichung (2) für einen Frequenzoffset von 16*fREF/RES = 16*0,5 MHz = 8 MHz steht, auf eine Folge cy aus Null- und Einswerten, deren Anzahlen übereinstimmen. Analog hierzu führen die FRAC-Werte 0 bzw. 31 auf eine Folge cy von Nullwerten entsprechend einem verschwindenden Frequenzoffset bzw. auf eine Folge cy von Einswerten entsprechend einem Frequenzoffset von 31*0,5 MHz = 15,5 MHz. Anstelle von zweistufigen Folgen mit binären Werten können mit Hilfe eines Sigma-Delta-Modulators der Ordnung zwei oder höher (M $\geq$ 2) auch höherstufige Folgen cy z.B. mit ganzzahligen Werten zwischen -1 und 2 (für M=2) erzeugt werden. Vorzugsweise wird ein Sigma-Delta-Modulator der Ordnung zwei verwendet.

Im Addierer 27b werden die vom Sigma-Delta-Modulator 27a erzeugten cy-Werte schließlich zum INT-Wert addiert und die Summenwerte INT+cy als zeitvarianter Teiler D dem schaltbaren Frequenzteiler 25 zugeführt. Mit Hilfe dieses zeitvarianten Teilers D, der im zeitlichen Mittel dem Faktor INT+FRAC/RES aus Gleichung (2) entspricht, realisiert der Frequenzteiler 25 die erforderliche Frequenzteilung.

Die Frequenzteilung durch einen zeitvarianten Teiler D=INT+cy bewirkt einen zusätzlichen zeitvarianten Phasenfehler, der durch die schaltbare Verzögerungseinheit 26 momentan kompensiert wird.

Die Bestimmungseinheit (DET) 27d bestimmt die Steuerworte dT vorzugsweise in Abhängigkeit von einem akkumulierten Signal acc1, das ein eingangsseitiger Akkumulator des Sigma-Delta-Modutators bereitstellt, der die FRAC-Werte akkumuliert. Während bei Sigma-Detta-Modulatoren erster Ordnung (M=1) die Werte der Steuerworte dT mit den Werten des akkumulierten Signals acc1 übereinstimmen, ist bei Sigma-Delta-Modulatoren einer Ordnung von zwei oder höher (M ≥ 2) vom akkumulierten Signal acc1 die Differenz aus dem Ausgangssignal cy ("erstes Überiaufsignal") des Sigma-Delta-Modulators 27a und dem ("zweiten") Überlaufsignal cy1 des Akkumulators zu subtrahieren.

Mit Hilfe des Sigma-Delta-Modulators können relativ nah an der Zielfrequenz liegenden Spektrallinien im Störanteil des Spektrums des VCO-Ausgangssignals sehr effektiv unterdrückt werden, so daß sich ein besonders hohes Signal/RauschVerhältnis im Nutzfrequenzbereich ergibt. Zusätzlich unterdrückt der Sigma-Delta-Modulator Störungen, die durch eventuelle Nichtlinearitäten der Verzögerungseinheit 26 hervorgerufen werden, was insbesondere dann von Vorteil ist, wenn das Verhältnis FRAC/RES einen Wert nahe null oder eins annimmt. Alternativ kann die Steuereinheit 27 statt eines Sigma-Delta-Modulators auch einen Akkumulator aufweisen.

Die Kalibrierungseinheit 28 ist eingangsseitig mit dem Referenzoszillator 21 und ausgangsseitig mit dem ersten Steuereingang der Verzögerungseinheit 26 verbunden. Aus dem Referenzsignal xREF leitet die Kalibrierungseinheit 28 das Steuersignal IB derart ab, daß es auf Verzögerungszeiten ΔT führt, mit denen die Verzögerungseinheit 26 den zusätzlichen zeitvarianten Phasenfehler momentan kompensiert.

Hierzu leitet die Kalibrierungseinheit 28 bevorzugt zwei Gesamtverzögerungszeiten T1, T2 aus dem Referenzsignal xREF ab und stellt das Steuersignal IB so ein, dass sich diese Gesamtverzögerungszeiten T1, T2 um ein vorgegebenes Zeitintervall unterscheiden. Vorzugsweise leitet die Kalibrierungseinheit 28 aus dem Referenzsignal xREF zwei Signale y1, y2 mit zwei Flanken ab und stellt das Steuersignal IB so ein, dass ein vorgegebenes Zeitintervall zwischen diesen Flanken liegt.

Das vorgegebene Zeitintervall ist bevorzugt aus der Periodendauer TREF = 1/fREF des Referenzsignals xREF abgeleitet. Vorzugsweise entspricht es der Periodendauer TREF des Referenzsignals oder einem Vielfachen dieser Periodendauer TREF. Alternativ kann das vorgegebene Zeitintervall einem nichtganzzahligen Vielfachen von TREF entsprechen oder eine verschwindende Dauer aufweisen.

In einer bevorzugten Ausführungsform weist die Kalibrierungseinheit 28 zur Bildung einer vom Steuersignal IB abhängigen ersten Gesamtverzögerungszeit T1 einen durch das Steuersignal gesteuerten ersten (Signal)Pfad und zur Bildung einer ebenfalls IB-abhängigen zweiten Gesamtverzögerungszeit T2 einen durch das Steuersignal gesteuerten zweiten (Signal)Pfad auf und ist ausgebildet, das Steuersignal IR so einzustellen, daß sich die beiden Gesamtverzögerungszeiten T1,T2 um einen vorgegebenen nichtverschwindenden wert eines ganzzahligen Vielfachen K der Periodendauer TREF=1/fREF des Referenzsignals xREF voneinander unterscheiden (K=1,2,3, ...). Hierdurch kann die Kalibrierungseinheit sehr einfach realisiert und sehr energiesparend betrieben werden. Im exemplarischen Fall von fREF=16 MHz beträgt TREF=62,5 ns. Anstelle von ganzzahligen Vielfachen von TREF können in weiteren Ausführungsformen andere feste, aus dem Referenzsignal xREF abgeleitete Zeitintervalle verwendet werden.

Die Gesamtverzögerungszeiten T1 und T2 werden hierbei vor allem von ersten bzw. zweiten Verzögerungseinheiten im ersten bzw. zweiten Pfad bestimmt, die im wesentlichen identisch zur schaltbaren Verzögerungseinheit 26 ausgestaltet (aufgebaut, implementiert) sind und ebenfalls vom Steuersignal IB angesteuert werden, denen aber vorgegebene kleinere Werte dT1 bzw. größere Werte dT2 des Steuerwortes zugeführt werden. Daher verursachen die ersten Verzögerungseinheiten jeweils kleinere und die zweiten Verzögerungseinheiten jeweils größere Verzögerungszeiten ΔT1 bzw. ΔT2, die jeweils vom Steuersignal IB abhängen (siehe Gleichung (1)). Im wesentlichen durch eine Vervielfachung dieser kleineren bzw. größeren Verzögerungszeiten ΔT1 bzw. ΔT2 ergeben sich schließlich die Gesamtverzögerungszeiten T1 bzw. T2, die sich bei einem kalibrierten Steuersignal IB um den o.g. Wert eines ganzzahliges Vielfachen K der Periodendauer TREF voneinander unterscheiden. Im unkalibrierten Zustand unterscheiden sich die Gesamtverzögerungszeiten T1, T2 im allgemeinen dagegen nicht um ein ganzzahliges Vielfaches K von TREF voneinander. Daher wird das Steuersignal IB so eingestellt, daß sich die Gesamtverzögerungszeiten T1, T2 um ein ganzzahliges Vielfaches K von TREF unterscheiden.

Die erfindungsgemäße Kalibrierung beruht also darauf, den variablen Anteil der Verzögerungszeit der schaltbaren Verzögerungseinheit 26, d.h. den zeitlichen Unterschied zwischen einer kleineren und einer größeren Verzögerungszeit ΔT nach Gleichung (1), im wesentlichen zu vervielfachen und das Steuersignal IB so einzustellen, daß der zeitliche Gesamtunterschied einem ganzzahligen Vielfachen K der Periodendauer TREF des hochpräzisen Referenzsignals entspricht.

Bei der nachfolgend mit Bezug auf die Figuren 3 und 4 beschriebenen Ausführungsform der Kalibrierungseinheit sind die ersten und zweiten Verzögerungseinheiten beispielhaft Teil eines ersten bzw. eines zweiten Ringoszillators. Auf diese Weise können die durch die einzelnen ersten und zweiten Verzögerungseinheiten verursachten Verzögerungszeiten ΔT1 bzw. ΔT2 aufwandsgünstig im wesentlichen vervielfacht werden. Wie oben erläutert werden auch hier die ersten Verzögerungseinheiten auf andere Verzögerungszeiten eingestellt als die zweiten Verzögerungseinheiten, und zwar so, daß sich im kalibrierten Zustand nach einer vorgegebenen Anzahl von Signalumläufen im ersten und zweiten Ringoszillator die erste Gesamtverzögerungszeit T1 von der zweiten Gesamtverzögerungszeit T2 um ein ganzzahliges Vielfaches K von TREF unterscheidet. Anstelle von Ringoszillatoren kann natürlich auch eine entsprechend erhöhte Anzahl von ersten und zweiten Verzögerungseinheiten vorgesehen werden.

Vorzugsweise werden die Ringoszillatoren ebenfalls mit einer Zeitdifferenz von K*TREF freigegeben, wobei der Ringoszillator mit den größeren Verzögerungszeiten zuerst gestartet wird. In diesem Fall sind die Ausgangssignale der Ringoszillatoren bzw. Pfade bei einem kalibrierten Steuersignal nach der vorgegebenen Anzahl von Umläufen phasengleich, so daß die Kalibrierung auf der Basis eines Phasenvergleichs der Ausgangssignale erfolgen. Anstelle auf die Phasengleichheit der Ausgangssignale abzuzielen, kann auch auf einen Phasenunterschied abgestellt werden, sofern die Ringoszillatoren zu entsprechend angepaßten Zeitpunkten, z.B. zeitgleich, gestartet werden.

Zur Einsparung von Betriebsenergie weist der in Figur 2 dargestellte Frequenzgenerator 20 neben einem normalen Betriebsmodus vorzugsweise auch einen Kalibrierungsmodus auf. Die Kalibrierungseinheit 28 wird nur dann mit Betriebsenergie versorgt, wenn sich der Frequenzgenerator im Kalibrierungsmodus befindet. Vorteilhaft wird der Kalibrierungsmodus periodisch, aber jeweils nur sehr kurzzeitig aktiviert, beispielsweise beim Aktivieren des Frequenzgenerators (d.h. bevor das VCO-Ausgangssignal yRF die Zielfrequenz erreicht hat) und dann z.B. alle 5 Minuten, um langsame Schwankungen z.B. infolge von Temperaturänderungen etc. zu kompensieren.

Figur 3 zeigt ein Blockschaltbild einer erfindungsgemäßen Kalibrierungseinheit 28. Die Kalibrierungseinheit (CAL) 28 weist einen ersten (Signal)Pfad 31, einen zweiten (Signal)Pfad 32, eine den Pfaden 31, 32 nachgeschaltete Phasendetektorschaltung (PDET) 33 sowie eine der Phasendetektorschaltung nachgeschaltete Strombereitstellungseinheit (IDAC) 34 auf. Die beiden Pfade 31, 32 sind eingangsseitig mit dem Referenzoszillator 21 verbunden (siehe Fig. 2). Die Strombereitstellungseinheit 34 ist ausgangsseitig sowohl mit der schaltbaren Verzögerungseinheit 26 (Fig. 2) als auch mit den Pfaden 31, 32 verbunden.

Den Pfaden 31, 32 wird eingangsseitig jeweils das Referenzsignal xREF des Referenzoszillators 21 zugeführt. Die beiden Pfade leiten aus dem Referenzsignal xREF ein erstes bzw. zweites Ausgangssignal y1 bzw. y2 ab, deren Phasen in der Phasendetektorschaltung 33 verglichen werden. Basierend auf diesem Vergleich erzeugt die Phasendetektorschaltung 33 ein Wort eines digitalen Signals A, dessen Wert einen in Anbetracht des Phasenvergleichs erforderlichen Steuerstrom IB repräsentiert. In der Strombereitstellungseinheit 34 wird dieses Wort des digitalen Signals A in einen Steuerstrom IB umgesetzt, der sowohl der schaltbaren Verzögerungseinheit 26 als auch den Pfaden 31, 32 zugeführt wird. Anstelle der bevorzugten Strombereitstellungseinheit 34 und des bevorzugten Steuerstromes (Biasstrom) IB kann alternativ eine Spannungsbereitstellungseinheit bzw. eine Steuerspannung vorgesehen sein.

Der erste Pfad 31 weist folgende in Reihe geschaltete Einheiten auf: eine eingangsseitig mit dem Referenzoszillator 21 verbundene Signalbereitstellungseinheit (SB) 35, einen ersten Ringoszillator (RO) 36a und einen ersten Zähler oder Teiler (CNT) 37a, der ausgangsseitig mit der Phasendetektorschaltung 33 verbunden ist. Analog hierzu weist der zweite Pfad 32 die besagte Signalbereitstellungseinheit 35, einen zweiten Ringoszillator 36b und einen zweiten Zähler oder Teiler 37b auf, der ebenfalls ausgangsseitig mit der Phasendetektorschaltung 33 verbunden ist. Die Ringoszillatoren 36a, 36b sind im wesentlichen identisch ausgestaltet (aufgebaut) und eingangsseitig jeweils mit der Strombereitstellungseinheit 34 verbunden. Dem ersten Ringoszillator 36a werden Steuerworte mit ersten Werten dT1 zugeführt, dem zweiten Ringoszillator 36b dagegen Steuerworte mit anderen zweiten Werten dT2.

Die Signalbereitstellungseinheit (SB) 35 leitet aus dem Referenzsignal xREF ein erstes Signal x1 mit einer ersten (z.B. steigenden) Flanke und ein zweites Signal x2 mit einer zweiten (z.B. steigenden) Flanke ab, wobei die beiden Flanken einen zeitlichen Abstand voneinander aufweisen, der einem ganzzahligen Vielfachen K der Periodendauer TREF des Referenzsignals xREF entspricht. Die erste Flanke (von x1) legt hierbei den zeitlichen Startpunkt der im ersten Pfad zu bildenden ersten Gesamtverzögerungszeit T1 fest, während die zweite Flanke (von x2) den zeitlichen Startpunkt der im zweiten Pfad zu bildenden zweiten Gesamtverzögerungszeit T2 fixiert.

Vorzugsweise entspricht der zeitliche Abstand der beiden Flanken genau einer Periodendauer TREF. In diesem Falle (K=1) ist die Einheit 35 z.B. als Hintereinanderschaltung von zwei jeweils mit dem Referenzsignal xREF getakteten D-Flipflops ausgeführt, deren Ausgänge die Signale x1 bzw. x2 bereitstellen.

Mit Hilfe der beiden Flanken der Signale x1, x2 werden die Ringoszillatoren (RO) 36a, 36b in einem definierten zeitlichen Abstand (K*TREF) voneinander gestartet. Im folgenden wird davon ausgegangen, daß zunächst der zweite Ringoszillator 36b und dann, eine Zeitspanne von K*TREF später, der erste Ringoszillator 36a gestartet wird. Selbstverständlich können auch umgekehrte Verhältnisse vorgesehen werden.

Nach dem jeweiligen Startzeitpunkt erzeugen die Ringoszillatoren ausgangsseitig Impulse, deren Periodendauern vom Steuersignal IB und - im Falle des ersten Ringoszillators 36a - den ersten Werten dT1 bzw. - im Falle des zweiten Ringoszillators 36b - den zweiten Werten dT2 abhängen. Die zweiten Werte dT2 werden hierbei größer gewählt als die ersten Werte dT1, so daß die vom zweiten Ringoszillator 36b generierten Impulse eine größere Periodendauer aufweisen als die Impulse des ersten, später gestarteten Ringoszillators 36a. Die Ringoszillatoren 36a, 36b werden nachstehend mit Bezug auf Fig. 4 näher erläutert.

Die Zähler bzw. Teiler (CNT) 37a und 37b zählen die vom Ringoszillator 36a bzw. 36b erzeugten Impulse und erzeugen beim Erreichen eines vorgegebenen Abbruchwertes Z eine erste (z.B. steigende) Flanke in ihrem (Überlauf-) Ausgangssignal y1 bzw. eine zweite (z.B. steigende) Flanke im Ausgangsignal y2. Diese beiden Flanken legen den zeitlichen Endpunkt der ersten Gesamtverzögerungszeit T1 bzw. der zweiten Gesamtverzögerungszeit T2 fest. Die Ausgangssignale y1, y2 der Zähler 37a, 37b werden der Phasendetektorschaltung 33 zugeführt. Die beiden Zähler 37a, 37b sind im wesentlichen identisch ausgestaltet (aufgebaut).

Die dT1- und dT2-Werte für die Ringoszillatoren 36a, 36b und der Abbruchwert Z der Zähler 37a, 37b werden so gewählt, daß sich die erste Gesamtverzögerungszeit T1 von der zweiten Gesamtverzögerungszeit T2 möglichst genau um den Wert K des ganzzahligen Vielfachen (vorzugsweise K=1) der Periodendauer TREF unterscheidet, wenn das Steuersignal IB eingestellt, d.h. kalibriert ist.

Die Phasendetektorschaltung (PDET) 33 stellt fest, ob die erste Flanke des Ausgangssignals y1 der zweiten Flanke des Ausgangssignals y2 vor- oder nacheilt. Hierzu weist die Phasendetektorschaltung 33 eingangsseitig beispielsweise über Kreuz verschaltete NAND-Gatter auf. Mit Hilfe einer nachgeschalteten logischen Einheit bestimmt die Phasendetektorschaltung 33 ein Wort eines digitales Signals A, dessen Wert den in Anbetracht des Phasenvergleichs zwischen den beiden Flanken erforderlichen Steuerstrom IB repräsentiert.

Unter Verwendung eines Referenzstromes Iref setzt die Strombereitstellungseinheit 34 (I-DAC) das Wort des digitalen Signals A in den entsprechenden Steuerstrom IB um, wobei näherungsweise die Beziehung IB = A*Iref + const. gilt. Die Strombereitstellungseinheit 34 ist vorzugsweise als digital programmierbare Stromquelle ausgebildet.

Vorzugsweise erfolgt die Einstellung des Steuerstroms IB nach dem Verfahren der sukzessiven Approximation. Hierbei wird zunächst in der Phasendetektorschaltung 33 das höchstwertige Bit der Worte des digitalen Signals A entsprechend dem Ergebnis des Phasenvergleichs von y1 und y2 eingestellt, während die niederwertigeren Bits vorläufig zu null gesetzt werden. In der Strombereitstellungseinheit 34 wird das so gebildete Wort A in einen Steuerstrom IB umgesetzt, der u.a. den Verzögerungsgliedern 41a, 41b der Ringoszillatoren zugeführt wird. Die mit diesem Steuerstrom IB erzeugten Ausgangssignale y1, y2 werden dann wiederum durch die Phasendetektorschaltung 33 in ihrer Phase verglichen, das zweithöchste Bit des digitalen Signals A entsprechend gesetzt usw., bis auch das niedrigstwertige Bit von A eingestellt ist. Die Bitbreite von A hängt von der erforderlichen Einstellgenauigkeit der Verzögerungszeit $\Delta T$ ab und beträgt beispielsweise 6 Bit.

Figur 4 zeigt ein Blockschaltbild des ersten Ringoszillators 36a. Dieser Ringoszillator umfaßt eine Reihenschaltung aus einem ersten NAND-Gatter 43a, insgesamt ND ersten Verzögerungseinheiten 41a und insgesamt NI ersten Invertern 42a, wobei der Ausgang der Reihenschaltung rückgekoppelt ist auf einen ersten Eingang des NAND-Gatters 43a und das Signal x1 einem zweiten Eingang des NAND-Gatters zugeführt wird. Die Zahl NI der ersten Inverter ist hierbei gerade, wobei NI=ND, falls ND gerade ist, oder aber NI=ND-1, falls ND ungerade ist. Den ersten Verzögerungseinheiten 41a wird das Steuersignal IB und erste Werte dT1 des Steuerwortes zugeführt. Die dT1-Werte können sich hierbei von Verzögerungsseinheit 41a zu Verzögerungseinheit 41a unterscheiden. Weiterhin können einzelne dT1-Werte vom Kanalindex CH bzw. der Zielfrequenz fRF abhängig sein.

Der zweite Ringoszillator 36b ist im wesentlichen identisch ausgestaltet wie der in Figur 4 dargestellte erste Ringoszillator 36a. Er umfaßt ein zweites NAND-Gatter 43b, insgesamt ND zweite Verzögerungseinheiten 41b und insgesamt NI zweite Inverter 42b, wobei diese Einheiten analog zu Fig. 4 verschaltet und im wesentlichen identisch mit den entsprechenden Einheiten aus Fig. 4 ausgestaltet sind. Den zweiten Verzögerungseinheiten 41b wird das Steuersignal IB und zweite Werte dT2 des Steuerwortes zugeführt, wobei sich die dT2-Werte von Verzögerungseinheit 41b zu Verzögerungseinheit 41b unterscheiden können und einzelne dT2-Werte ebenfalls vom Kanalindex CH bzw. der Zielfrequenz fRF abhängig sein können. Der zweite Ringoszillator 36b unterscheidet sich vom ersten Ringoszillator also lediglich darin, daß dT2- statt dT1-Werte und das Signal x2 statt x1 zugeführt werden.

Jede erste Verzögerungseinheit 41a und jede zweite Verzögerungseinheit 41b ist hierbei im wesentlichen identisch mit der schaltbaren Verzögerungseinheit 26 aus Figur 2 aufgebaut. Die ersten und zweiten Inverter 42a, 42b stellen sicher, daß den jeweiligen Verzögerungseinheiten eine ausreichend lange Erholungzeit verbleibt, bevor sie auf definierte Weise auf die nächste Flanke reagieren.

Die Ringoszillatoren 36a, 36b werden durch einen High-Pegel am Eingang des jeweiligen NAND-Gatters 43a, 43b gestartet. Jede erste Verzögerungseinheit 41a verzögert das an ihrem Eingang anliegende Signal um eine von IB und dem jeweils anliegenden dT1-Wert abhängige erste Zeitspanne $\Delta T1$, während jede zweite Verzögerungseinheit 41b das an ihrem Eingang anliegende Signal um eine von IB und dem jeweils anliegenden dT2-Wert abhängige zweite Zeitspanne $\Delta T2$ verzögert. Aufgrund des im wesentlichen identischen Aufbaus der Verzögerungseinheiten 41a, 41b, 26 entsprechen die Zeitspannen $\Delta T1$ bzw. $\Delta T2$ denjenigen Zeitspannen, die sich aus Gleichung (1) für dT=dT1 bzw. dT=dT2 ergeben, d.h. denjenigen Verzögerungszeiten $\Delta T$, die die schaltbare Verzögerungseinheit 26 hervorrufen würde, wenn das Steuerwort dT den Wert dT1 bzw. dT2 annehmen würde. Da der dT2-Wert größer ist als der dT1-Wert, ist die zweite Zeitspanne $\Delta T2$ hierbei länger als die erste Zeitspanne $\Delta T1$. Die mit Bezug auf Fig. 3 erläuterten Gesamtverzögerungszeiten T1, T2 ergeben sich aus der Summe der Zeitspannen $\Delta T1$ bzw. $\Delta T2$ und der Anzahl der Signalumläufe im jeweiligen Ringoszillator.

Beispielsweise können pro Ringoszillator ND=4 Verzögerungselemente und NI=4 Inverter vorgesehen werden. Die vier dT1-Werte nehmen beispielsweise jeweils den Wert 24 an, während zwei dT2-Werte einen Wert von 100, der dritte dT2-Wert je nach Kanalindex CH den Wert 100 oder 101 und der vierte dT2-Wert je nach Kanalindex CH einen Wert zwischen 105 und 113 annimmt.

Der mit Bezug auf die Figuren 2 bis 4 beschriebene PLL-Frequenzgenerator ermöglicht eine Kompensation des Phasenfehlers mit hoher Genauigkeit und Auflösung. Auflösungen von bis zu 8 Bit und Genauigkeiten im Pikosekundenbereich sind relativ einfach realisierbar. Simulationen der Anmelderin haben gezeigt, daß sich die Störmodulationen so um ca. 40 dB unterdrücken lassen. Die mit Bezug auf die Figuren 3 und 4 beschriebene Kalibrierungseinheit 28 ist einfach zu realisieren und energiesparend zu betreiben.

Während der mit Bezug auf Figur 2 beschriebene PLL-Frequenzgenerator ohne Kalibrierungseinheit einen Stromverbrauch von ca. 150µA aufweist, erfordert die mit Bezug auf die Figuren 3 und 4 beschriebene Kalibrierungseinheit 28 einen Strom in der Größenordnung von 1 mA. Da die Kalibrierungseinheit keine Regelung, sondern eine Kalibrierung auf der Basis des hochpräzisen Referenzsignals durchführt, ist es ausreichend, die Kalibrierungseinheit jeweils nur sehr kurzzeitig in Betrieb zu nehmen. Wie oben mit Bezug auf Fig. 2 erläutert weist der Frequenzgenerator hierzu vorzugsweise einen Kalibrierungsmodus auf und versorgt die Kalibrierungseinheit nur dann mit Betriebsenergie, wenn der Kalibrierungsmodus aktiv ist, z.B. bei der Aktivierung des Frequenzgenerators und anschließend alle 5 Minuten. Auf diese Art läßt sich der mittlere Stromverbrauch des gesamten Frequenzgenerators im Vergleich zu einer kontinuierlichen Regelung drastisch reduzieren.

Obgleich die vorliegende Erfindung vorstehend anhand von Ausführungsbeispielen beschrieben wurde, ist sie nicht darauf beschränkt, sondern auf vielfältige Weise modifizierbar. So ist die Erfindung beispielsweise weder auf WPANs an sich, noch auf WPANs gemäß IEEE 802.15.4 bzw. die dort spezifizierten Frequenzbänder, Zielfrequenzwerte, Spektralmasken etc. beschränkt. Auch ist die Erfindung nicht auf eine bestimmte Referenzfrequenz, Frequenzauflösung oder eine bestimmte Architektur der PLL, der Verzögerungseinheit, des Frequenzteilers oder der Steuereinheit beschränkt. Die Erfindung kann vielmehr vorteilhaft in unterschiedlichsten drahtlosen oder -gebundenen Kommunikationssystemen eingesetzt werden.

Bezugszeichenliste

| | |
|---|---|
| 10 | Datenübertragungssystem / WPAN nach IEEE 802.15.4 |
| 11-13 | Sende-/Empfangsvorrichtung |
| 14 | Antenne |
| 15 | Sende-/Empfangseinheit (transceiver, TRX) |
| 16 | Kontrolleinheit (CTRL) |
| 20 | PLL-Frequenzgenerator |
| 21 | Referenzoszillator |
| 22 | Phasen(differenz)detektor / Ladungspumpe (PD/CP) |
| 23 | Schleifenfilter (loop filter, LF) |
| 24 | spannungsgesteuerter Oszillator (VCO) |
| 25 | schaltbarer Frequenzteiler (DIV) |
| 26 | schaltbare Verzögerungseinheit (DEL) |
| 27 | Steuereinheit (CTL) |
| 27a | Sigma-Detta-Modulator ($\Sigma\Delta$) |
| 27b | Addierer |
| 27c | Mapping-Einheit (MAP) |
| 27d | Bestimmungseinheit (DET) |
| 28 | Kalibrierungseinheit (CAL) |
| 31, 32 | erster bzw. zweiter Pfad |
| 33 | Phasendetektorschaltung (PDET) |
| 34 | Strombereitstellungseinheit (IDAC) |
| 35 | Signalbereitstellungseinheit (SB) |
| 36a, 36b | erster bzw. zweiter Ringoszillator (RO) |
| 37a, 37b | erster bzw. zweiter Zähler bzw. Teiler (CNT) |
| 41a, 41b | erste bzw. zweite Verzögerungseinheit(en) (DEL) |
| 42a, 42b | erste bzw. zweite Inverter |
| 43a, 43b | erstes bzw. zweites NAND-Gatter |

| | |
|---|---|
| CAL | Kalibierungseinheit |
| CNT | Zähler bzw. Teiler |
| CTL | Steuereinheit |
| CTRL | Kontrolleinheit |
| DEL | Verzögerungseinheit |
| DET | Bestimmungseinheit zum Bestimmen von dT |
| DIV | schaltbarer Frequenzteiler; multi modulus divider |

| IDAC | Strombereitstellungseinheit |
|---|---|
| ISM | industrial, scientific, medical (Frequenzband bei 2,4 GHz) |
| LF | loop filter (Schleifenfilter) |
| MAP | Mapping-Einheit |
| MMD | multi modulus divider |
| PD/CP | Phasendetektor / Ladungspumpe (charge pump) |
| PDET | Phasendetektorschaltung |
| PLL | phase locked loop |
| PN | pseudo-noise |
| QPSK | quarternary phase shift keying |
| RO | Ringoszillator |
| SB | Signalbereitstellungseinheit |
| TRX | Sende-/Empfangseinheit, transceiver |
| VCO | voltage controlled oscillator (spannungsgesteuerter Oszillator) |
| WPAN | Wireless Personal Area Network |

| $\Delta T$ | Verzögerungszeit |
|---|---|
| $\Delta T1$, $\Delta T2$ | erste bzw. zweite Zeitspanne |
| $\Sigma\Delta$ | Sigma-Delta-Modulator |
| A | digitales Signal |
| acc1 | akkumuliertes Signal |
| CH | Index des gewünschten Kanals |
| D | Teiler bei der Frequenzteilung |
| dT | Steuerwort |
| dT1, dT2 | erster bzw. zweiter Wert von dT |
| fC | Chiptakt |
| fDIV | Frequenz des frequenzgeteilten Signals xDIV |
| FRAC | "gebrochenrationaler" Anteil des Teilers D |
| fREF | Frequenz des Referenzsignals xREF (fREF=1 /TREF) |
| fRF | Zielfrequenz, Frequenz des Ausgangssignals yRF |
| IB | Steuersignal |
| iCP | definierter Strom der Ladungspumpe |
| INT | ganzzahliger Anteil des Teilers D |
| K | ganzzahliger Wert |
| M | Ordnung des Sigma-Delta-Modulators |
| ND | Anzahl der ersten bzw. zweiten Verzögerungseinheiten |
| NI | Anzahl der ersten bzw. zweiten Inverter |
| t0 | Grundverzögerung |
| T1, T2 | erste bzw. zweite Gesamtverzögerungszeit |
| ts | Schrittweite der Verzögerung |
| TREF | Periodendauer von xREF (TREF=1/fREF) |
| vt | Steuerspannung |
| x1, x2 | erstes bzw. zweites Eingangssignal |
| xDIV | frequenzgeteiltes Signal |
| xREF | Referenzsignal |
| xT | verzögertes Signal |
| y1, y2 | erstes bzw. zweites Ausgangssignal |
| yRF | Ausgangssignal des VCO bzw. des PLL-Frequenzgenerators |
| Z | Zähler-Abbruchwert |

**Patentansprüche**

1. PLL-Frequenzgenerator (20) zum Generieren eines Ausgangssignals (yRF) mit einer einstellbaren Zielfrequenz (fRF), enthaltend:

   a) einen spannungsgesteuerten Oszillator (24) zum Generieren des Ausgangssignals (yRF) in Abhängigkeit von einer Steuerspannung (vt),

b) einen mit dem spannungsgesteuerten Oszillator (24) verbundenen schaltbaren Frequenzteiler (25), der ausgebildet ist, aus dem Ausgangssignal (yRF) ein frequenzgeteiltes Signal (xDIV) abzuleiten, dessen Momentanfrequenz (fDIV) von einem Wert eines einstellbaren Teilers (D) abhängt,

c) eine mit dem Frequenzteiler (25) verbundene schaltbare Verzögerungseinheit (26), die ausgebildet ist, ein verzögertes Signal (xT) zu bilden, indem das frequenzgeteilte Signal (xDIV) um Verzögerungszeiten (T) verzögert wird, die jeweils von einem Steuerwort (dT) und einem Steuersignal (IB) abhängen, und

d) einen mit der schaltbaren Verzögerungseinheit (26) verbundenen Phasendetektor (22), der ausgebildet ist, die Phasendifferenz zwischen einem Referenzsignal (xREF) und dem verzögerten Signal (xT) zu bestimmen und zur Bildung der Steuerspannung (vt) bereitzustellen, bei dem

e) eine mit der schaltbaren Verzögerungseinheit (26) verbundene Kalibrierungseinheit (28) vorgesehen ist, die ausgebildet ist, das Steuersignal (IB) allein aus dem Referenzsignal (xREF) abzuleiten, wobei der Kalibrierungseinheit das reine Referenzsignal zugeführt wird.

2. PLL-Frequenzgenerator nach Anspruch 1, **dadurch gekennzeichnet, daß** die Kalibrierungseinheit (28) ausgebildet ist, aus dem Referenzsignal (xREF) zwei Gesamtverzögerungszeiten (T1, T2) abzuleiten und das Steuersignal (IB) so einzustellen, dass sich die Gesamtverzögerungszeiten (T1, T2) um ein vorgegebenes Zeitintervall unterscheiden.

3. PLL-Frequenzgenerator nach Anspruch 1 oder 2, **dadurch gekennzeichnet, daß** die Kalibrierungseinheit (28) ausgebildet ist, aus dem Referenzsignal (xREF) zwei Signale (y1, y2) mit zwei Flanken abzuleiten und das Steuersignal (IB) so einzustellen, dass ein vorgegebenes Zeitintervall zwischen den Flanken liegt.

4. PLL-Frequenzgenerator nach Anspruch 2 oder 3, **dadurch gekennzeichnet, dass** das vorgegebene Zeitintervall aus der Periodendauer (TREF) des Referenzsignals (xREF) abgeleitet ist.

5. PLL-Frequenzgenerator nach einem der Ansprüche 2 bis 4, **dadurch gekennzeichnet, dass** das vorgegebene Zeitintervall der Periodendauer (TREF) des Referenzsignals (xREF) oder einem Vielfachen der Periodendauer (TREF) des Referenzsignals (xREF) entspricht.

6. PLL-Frequenzgenerator nach einem der vorhergehenden Ansprüche, **dadurch gekennzeichnet, daß** die Kalibrierungseinheit (28) zur Bildung einer vom Steuersignal (IB) abhängigen ersten Gesamtverzögerungszeit (T1) einen durch das Steuersignal (IB) gesteuerten ersten Pfad (31) und zur Bildung einer vom Steuersignal (IB) abhängigen zweiten Gesamtverzögerungszeit (T2) einen durch das Steuersignal (IB) gesteuerten zweiten Pfad (32) aufweist und ausgebildet ist, das Steuersignal (IB) so einzustellen, daß sich die erste Gesamtverzögerungszeit (T1) von der zweiten Gesamtverzögerungszeit (T2) um einen vorgegebenen nichtverschwindenden Wert eines ganzzahligen Vielfachen (K) der Periodendauer (TREF) des Referenzsignals (xREF) unterscheidet.

7. PLL-Frequenzgenerator nach Anspruch 6, **dadurch gekennzeichnet, daß** die Kalibrierungseinheit (28) ausgebildet ist, das Steuersignal (IB) so einzustellen, daß sich die erste Gesamtverzögerungszeit (T1) von der zweiten Gesamtverzögerungszeit (T2) um eine (K=1) Periodendauer (TREF) unterscheidet.

8. PLL-Frequenzgenerator nach Anspruch 6 oder 7, **dadurch gekennzeichnet, daß** der erste Pfad (31) zur Bildung der ersten Gesamtverzögerungszeit (T1) einen durch das Steuersignal (IB) gesteuerten ersten Ringoszillator (36a) und der zweite Pfad (32) zur Bildung der zweiten Gesamtverzögerungszeit (T2) einen durch das Steuersignal (IB) gesteuerten zweiten Ringoszillator (36b) aufweisen, wobei der erste Pfad (31) und der zweite Pfad (32) derart ausgestaltet sind, daß sich die erste Gesamtverzögerungszeit (T1) von der zweiten Gesamtverzögerungszeit (T2) um den vorgegebenen nichtverschwindenden Wert des ganzzahligen Vielfachen (K) der Periodendauer (TREF) unterscheidet, wenn das Steuersignal (IB) eingestellt ist.

9. PLL-Frequenzgenerator nach Anspruch 8, **dadurch gekennzeichnet, daß** der erste Ringoszillator (36a) und der zweiten Ringoszillator (36b) im Wesentlichen identisch ausgestaltet sind.

10. PLL-Frequenzgenerator nach Anspruch 8 oder 9, **dadurch gekennzeichnet, daß**

a) der erste Ringoszillator (36a) mindestens eine durch das Steuersignal (IB) gesteuerte erste Verzögerungseinheit (41a) aufweist, die ausgebildet ist, ein an ihrem Eingang anliegendes Signal um eine vom Steuersignal (IB) abhängige erste Zeitspanne ($\Delta$T1) zu verzögern, die derjenigen nichtverschwindenden Verzögerungszeit ($\Delta$T>0) entspricht, die die schaltbare Verzögerungseinheit (26) hervorruft, wenn das Steuerwort (dT) einen ersten Wert (dT1) annimmt, und

b) der zweite Ringoszillator (36b) mindestens eine durch das Steuersignal (IB) gesteuerte zweite Verzögerungseinheit (41b) aufweist, die ausgebildet ist, ein an ihrem Eingang anliegendes Signal um eine vom Steuersignal (IB) abhängige zweite Zeitspanne ($\Delta$T2) zu verzögern, die derjenigen Verzögerungszeit ($\Delta$T) entspricht, die die schaltbare Verzögerungseinheit (26) hervorruft, wenn das Steuerwort (dT) einen zweiten Wert (dT2) annimmt, wobei die zweite Zeitspanne ($\Delta$T2) länger als die erste Zeitspanne ($\Delta$T1) ist.

11. PLL-Frequenzgenerator nach einem der Ansprüche 6 bis 9, **dadurch gekennzeichnet, daß**

a) der erste Pfad (31) zur Bildung der ersten Gesamtverzögerungszeit (T1) mindestens eine durch das Steuersignal (IB) gesteuerte erste Verzögerungseinheit (41a) aufweist, die ausgebildet ist, ein an ihrem Eingang anliegendes Signal um eine vom Steuersignal (IB) abhängige erste Zeitspanne ($\Delta$T1) zu verzögern, die derjenigen nichtverschwindenden Verzögerungszeit ($\Delta$T>0) entspricht, die die schaltbare Verzögerungseinheit (26) hervorruft, wenn das Steuerwort (dT) einen ersten Wert (dT1) annimmt, und
b) der zweite Pfad (32) zur Bildung der zweiten Gesamtverzögerungszeit (T2) mindestens eine durch das Steuersignal (IB) gesteuerte zweite Verzögerungseinheit (41 b) aufweist, die ausgebildet ist, ein an ihrem Eingang anliegendes Signal um eine vom Steuersignal (IB) abhängige zweite Zeitspanne ($\Delta$T2) zu verzögern, die derjenigen Verzögerungszeit ($\Delta$T) entspricht, die die schaltbare Verzögerungseinheit (26) hervorruft, wenn das Steuerwort (dT) einen zweiten Wert (dT2) annimmt, wobei die zweite Zeitspanne ($\Delta$T2) länger als die erste Zeitspanne ($\Delta$T1) ist.

12. PLL-Frequenzgenerator nach Anspruch 10 oder 11, **dadurch gekennzeichnet, daß** die erste(n) Verzögerungseinheit(en) (41a), die zweite(n) Verzögerungseinheit(en) (41b) und die schaltbare Verzögerungseinheit (26) im wesentlichen identisch ausgestaltet sind.

13. PLL-Frequenzgenerator nach einem der Ansprüche 10 bis 12, **dadurch gekennzeichnet, daß** der erste Wert bzw. die ersten Werte (dT1) und der zweite Wert bzw. die zweiten Werte (dT2) so gewählt sind, daß sich die erste Gesamtverzögerungszeit (T1) von der zweiten Gesamtverzögerungszeit (T2) um den vorgegebenen nichtverschwindenden Wert des ganzzahligen Vielfachen (K) der Periodendauer (TREF) unterscheidet, wenn das Steuersignal (IB) eingestellt ist.

14. PLL-Frequenzgenerator nach einem der Ansprüche 6 bis 13, **dadurch gekennzeichnet, daß**

a) der erste Pfad (31) ausgebildet ist, ein erstes Ausgangssignal (y1) mit einer ersten Flanke bereitzustellen,
b) der zweite Pfad (32) ausgebildet ist, ein zweites Ausgangssignal (y2) mit einer zweiten Flanke bereitzustellen,
c) die Kalibrierungseinheit (28) eine Phasendetektorschaltung (33) aufweist, die ausgebildet ist, festzustellen, ob die erste Flanke der zweiten Flanke vor- oder nacheilt und ein Wort eines digitalen Signals (A) zu erzeugen, dessen Wert einen in Anbetracht dieser Feststellung erforderlichen Wert des Steuersignals (IB) repräsentiert.

15. PLL-Frequenzgenerator nach einem der vorhergehenden Ansprüche, wobei das Steuersignal (IB) als Steuerstrom ausgebildet ist.

16. PLL-Frequenzgenerator nach einem der vorhergehenden Ansprüche, **dadurch gekennzeichnet, daß** der PLL-Frequenzgenerator einen Kalibrierungsmodus aufweist und ausgebildet ist, die Kalibrierungseinheit (28) nur dann mit Betriebsenergie zu versorgen, wenn der Kalibrierungsmodus aktiv ist.

17. PLL-Frequenzgenerator nach einem der vorhergehenden Ansprüche, **dadurch gekennzeichnet, daß** eine mit der schaltbaren Verzögerungseinheit (26) verbundene Steuereinheit (27) vorgesehen ist, die ausgebildet ist, die Steuerworte (dT) zu bestimmen.

18. PLL-Frequenzgenerator nach Anspruch 17, **dadurch gekennzeichnet, daß** die Steuereinheit (27) einen Sigma-Delta-Modulator (27a) aufweist und ausgebildet ist, die Steuerworte (dT) in Abhängigkeit von mindestens einem vom Sigma-Delta-Modulator bereitgestellten Signal zu bestimmen.

19. PLL-Frequenzgenerator nach Anspruch 18, **dadurch gekennzeichnet, daß**

a) der Sigma-Delta-Modulator (27a) einen Akkumulator aufweist, der zum Akkumulieren eines Eingangssignals (FRAC) des Sigma-Delta-Modulators und zum Bereitstellen eines akkumulierten Signals (acc1) ausgebildet ist, und

b) die Steuereinheit (27) ausgebildet ist, die Steuerworte (dT) in Abhängigkeit vom akkumulierten Signal (acc1) zu bestimmen.

**20.** PLL-Frequenzgenerator nach Anspruch 19, **dadurch gekennzeichnet, daß**

a) die Steuereinheit (27) einen Sigma-Delta-Modulator (27a) zweiter oder höherer Ordnung aufweist, der ausgebildet ist, ein erstes Überlaufsignal (cy) und ein zweites Überlaufsignal (cy1) bereitzustellen,
b) die Steuereinheit (27) ausgebildet ist, die Steuerworte (dT) in Abhängigkeit vom ersten und zweiten Überlaufsignal (cy, cy1) zu bestimmen.

**21.** PLL-Frequenzgenerator nach Anspruch 20, **dadurch gekennzeichnet, daß** ein Sigma-Delta-Modulator (27a) zweiter Ordnung vorgesehen ist.

**22.** Sende-/Empfangsvorrichtung (11-13), insbesondere für ein Datenübertragungssystem (10) nach dem IEEE-Standard 802.15.4, enthaltend eine Antenne (14) sowie eine mit der Antenne verbundene Sende-/Empfangseinheit (15) zum Senden und Empfangen von Daten insbesondere nach IEEE 802.15.4, mit einem PLL-Frequenzgenerator (20) nach einem der Ansprüche 1 bis 21.

**23.** Integrierte Schaltung, insbesondere für eine Sende-/Empfangsvorrichtung nach Anspruch 22, mit einem PLL-Frequenzgenerator (20) nach einem der Ansprüche 1 bis 21.

**Claims**

**1.** Phase-locked-loop frequency generator (20) for generating an output signal (yRF) with a settable target frequency (fRF), comprising:

a) a voltage-controlled oscillator (24) for generating the output signal (yRF) in dependence on a control voltage (vt),
b) a switchable frequency divider (25) which is connected with the voltage-controlled oscillator (24) and which is constructed to derive from the output signal (yRF) a frequency-divided signal (xDIV) of which the instantaneous frequency (fDIV) depends on a value of a settable divider (D),
c) a switchable delay unit (26) which is connected with the frequency divider (25) and which is constructed to form a delayed signal (xT) in that the frequency-divided signal (xDIV) is delayed by delay times (T) dependent on a control word (dT) and a control signal (IB) and
d) a phase detector (22) which is connected with the switchable delay unit (26) and which is constructed to determine the phase difference between a reference signal (xREF) and the delayed signal (xT) and to provide for formation of the control voltage (vt), in which
e) a calibrating unit (28) connected with the switchable delay unit (26) and constructed to derive the control signal (IB) solely from the reference signal (xREF) is provided, wherein the pure reference signal is fed to the calibrating unit.

**2.** Phase-locked-loop frequency generator according to claim 1, **characterised in that** the calibrating unit (28) is constructed to derive two total delay times (T1, T2) from the reference signal (xREF) and to so set the control signal (IB) that the total delay times (T1, T2) differ by a predetermined time interval.

**3.** Phase-locked-loop frequency generator according to claim 1 or 2, **characterised in that** the calibrating unit (28) is constructed to derive two signals (y1, y2) with two flanks from the reference signal (xREF) and to so set the control signal (IB) that a predetermined time interval is present between the flanks.

**4.** Phase-locked-loop frequency generator according to claim 2 or 3, **characterised in that** the predetermined time interval is derived from the period duration (TREF) of the reference signal (xREF).

**5.** Phase-locked-loop frequency generator according to any one of claims 2 to 4, **characterised in that** the predetermined time interval corresponds with the period duration (TREF) of the reference signal (xREF) or with a multiple of the period duration (TREF) of the reference signal (xREF).

**6.** Phase-locked-loop frequency generator according to any one of the preceding claims, **characterised in that** the calibrating unit (28) has for formation of a first total delay time (T1) dependent on the control signal (IB) a first path (31) controlled by the control signal (IB) and for formation of a second total delay time (T2) dependent on the control signal (IB) a second path (32) controlled by the control signal (IB) and is constructed to so set the control signal (IB) that the first total delay time (T1) differs from the second total delay time (T2) by a predetermined not-insignificant value of a whole-number multiple (K) of the period duration (TREF) of the reference signal (xREF).

7. Phase-locked-loop frequency generator according to claim 6, **characterised in that** a calibrating unit (28) is constructed to so set the control signal (IB) that the first total delay time (T1) differs from the second total delay time (T2) by a (K=1) period duration (TREF).

8. Phase-locked-loop frequency generator according to claim 6 or 7, **characterised in that** the first path (31) for formation of the first total delay time (T1) comprises a first ring oscillator (36a) controlled by the control signal (IB) and the second path (32) for formation of the second total delay time (T2) comprises a second ring oscillator (36b) controlled by the control signal (IB), wherein the first path (31) and the second path (32) are formed in such a manner that the first total delay time (T1) differs from the second total delay time (T2) by the predetermined not-insignificant value of the whole-number multiple (K) of the period duration (TREF) when the control signal (IB) is set.

9. Phase-locked-loop frequency generator according to claim 8, **characterised in that** the first ring oscillator (36a) and the second ring oscillator (36b) are constructed to be substantially identical.

10. Phase-locked-loop frequency generator according to claim 8 or 9, **characterised in that**

a) the first ring oscillator (36a) comprises at least one first delay unit (41a) which is controlled by the control signal (IB) and which is constructed to delay a signal, which is applied to its input, by a first time span ($fT1$), which is dependent on the control signal (IB) and which corresponds with that not-insignificant delay time ($fT>0$) which produces the switchable delay unit (26) when the control word (dT) adopts a first value (dT1), and
b) the second ring oscillator (36b) comprises at least one second delay unit (41 b) which is controlled by the control signal (IB) and delays a signal, which is applied to its input, by a second time span ($fT2$), which is dependent on the control signal (IB) and which corresponds with that delay time ($fT$) produced by the switchable delay unit (26) when the control word (dT) adopts a second value (dT2), wherein the second time span ($fT2$) is longer than the first time span ($fT1$).

11. Phase-locked-loop frequency generator according to any one of claims 6 to 9,
**characterised in that**

a) the first path (31) comprises for formation of the first total delay time (T1) at least one first delay unit (41a) which is controlled by the control signal (IB) and which is constructed to delay a signal, which is applied to its input, by a first time span ($fT1$), which is dependent on the control signal (IB) and which corresponds with that not-insignificant delay time ($fT>0$) producing the switchable delay unit (26) when the control word (dT) adopts a first value (dT1), and
b) the second path (32) comprises for formation of the second total delay time (T2) at least one second delay unit (41 b) which is controlled by the control signal (IB) and which is constructed to delay a signal, which is applied to its input, by a second time span ($fT2$), which is dependent on the control signal (IB) and which corresponds with that delay time ($fT2$) producing the switchable delay unit (26) when the control word (dT) adopts a second value (dT2), wherein the second time span ($fT2$) is longer than the first time span ($fT1$).

12. Phase-locked-loop frequency generator according to claim 10 or 11, **characterised in that** the first delay unit or units (41a), the second delay unit or units (41b) and the switchable delay unit (26) are of substantially identical construction.

13. Phase-locked-loop frequency generator according to any one of claims 10 to 12, **characterised in that** the first value or the first values (dT1) and the second value or the second values (dT2) are so selected that the first total delay time (T1) differs from the second total delay time (T2) by the predetermined not-insignificant value of the whole-number multiple (K) of the period duration (TREF) when the control signal (IB) is set.

14. Phase-locked-loop frequency generator according to any one of claims 6 to 13, **characterised in that**

a) the first path (31) is constructed to provide a first output signal (y1) with a first flank,

b) the second path (32) is constructed to provide a second output signal (y2) with a second flank and

c) the calibrating unit (28) comprises a phase detector circuit (33) which is constructed to establish whether the first flank leads or trails the second flank and to generate a word of a digital signal (A), the value of which represents a value, which is required with regard to fixing thereof, of the control signal (IB).

15. Phase-locked-loop frequency generator according to any one of the preceding claims, wherein the control signal (IB) is constructed as a control current.

16. Phase-locked-loop frequency generator according to any one of the preceding claims, **characterised in that** the phase-locked-loop frequency generator has a calibrating mode and is constructed to supply the calibrating unit (28) with operating energy only when the calibrating mode is active.

17. Phase-locked-loop frequency generator according to any one of the preceding claims, **characterised in that** a control unit (27) connected with the switchable delay unit (27) and constructed to determine the control words (dT) is provided.

18. Phase-locked-loop frequency generator according to claim 17, **characterised in that** the control unit (27) has a sigma-delta modulator (27a) and is constructed to determine the control words (dT) in dependence on at least one signal provided by the sigma-delta modulator.

19. Phase-locked-loop frequency generator according to claim 18, **characterised in that**

a) the sigma-delta modulator (27a) comprises an accumulator constructed for accumulating an input signal (FRAC) of the sigma-delta modulator and for providing an accumulated signal (acc1) and

b) the control unit (27) is constructed to determine the control words (dT) in dependence on the accumulated signal (acc1).

20. Phase-locked-loop frequency generator according to claim 19, **characterised in that**

a) the control unit (27) comprises a sigma-delta modulator (27a) of second or higher order which is constructed to provide a first overflow signal (cy) and a second overflow signal (cy1) and

b) the control unit (27) is constructed to determine the control words (dT) in dependence on the first and second overflow signals (cy, cy1).

21. Phase-locked-loop frequency generator according to claim 20, **characterised in that** a sigma-delta modulator (27a) of second order is provided.

22. Transmitting/receiving device (11-13), particularly for a data transmission system (10) according to the IEEE Standard 802.15.4, comprising an antenna (14) as well as a transmitting/receiving unit (15), which is connected with the antenna, for transmitting and receiving data, particularly according to IEEE 802.15.4, with a phase-locked-loop frequency generator (20) according to any one of claims 1 to 21.

23. Integrated circuit, particularly for a transmitting/receiving device according to claim 22 with a phase-locked-loop frequency generator (20) according to any one of claims 1 to 21.

**Revendications**

1. Générateur de fréquence à boucle de phase (20) pour générer un signal de sortie (yRF) à fréquence cible réglable (fRF), comprenant :

a) un oscillateur commandé en tension (24) pour générer le signal de sortie (yRF) en fonction d'une tension de commande (vt),

b) un diviseur de fréquence (25) connectable relié à l'oscillateur commandé en tension (24), qui est conçu pour déduire d'un signal de sortie (yFR) un signal à fréquence divisée (xDIV), dont la fréquence instantanée (fDIV) dépend d'une valeur d'un diviseur réglable (D),

c) une unité de retard (26) connectable reliée au diviseur de fréquence (25) conçue pour former un signal retardé (xT) en retardant le signal à fréquence divisée (xDIV) de durées de retard (T) dépendant à chaque fois d'une terme de commande (dT) et d'un signal de commande (IB), et

d) un détecteur de phase (22) relié à l'unité de retard connectable (26), qui est conçu pour déterminer la différence de phase entre un signal de référence (xREF) et le signal retardé (xT) et la fournir pour constituer la tension de commande (vt), dans lequel

e) on prévoit une unité de calibrage (28) reliée à l'unité de retard connectable (26) qui est conçue pour produire le signal de commande (IB) issu uniquement du signal de référence (xREF), le signal de référence pur étant amené à l'unité de calibrage.

**2.** Générateur de fréquence à boucle de phase selon la revendication 1, **caractérisé en ce que** l'unité de calibrage (28) est conçue pour déduire du signal de référence (xREF) deux durées de retard totales (T1, T2) et calibrer le signal de commande (IB) de telle façon que les durées de retard totales (T1, T2) se distinguent par un intervalle de temps prédéfini.

**3.** Générateur de fréquence à boucle de phase selon la revendication 1 ou 2, **caractérisé en ce que** l'unité de calibrage (28) est conçue pour déduire du signal de référence (xREF) deux signaux (y1, y2) à deux flancs, et pour calibrer le signal de commande (IB) de telle façon qu'il existe un intervalle de temps prédéfini entre les deux flancs.

**4.** Générateur de fréquence à boucle de phase selon la revendication 2 ou 3, **caractérisé en ce que** l'intervalle de temps prédéfini est obtenu à partir de la durée d'une période (TREF) du signal de référence (xREF).

**5.** Générateur de fréquence à boucle de phase selon l'une quelconque des revendications 2 à 4, **caractérisé en ce que** l'intervalle de temps prédéfini correspond à la durée d'une période (TREF) du signal de référence (xREF) ou à un multiple de la durée d'une période (TREF) du signal de référence (xREF).

**6.** Générateur de fréquence à boucle de phase selon l'une quelconque des revendications précédentes, **caractérisé en ce que** l'unité de calibrage (28) présente un premier chemin (31) commandé par le signal de commande (IB) pour la formation d'une première durée de retard totale (T1) dépendante du signal de commande (IB) et un deuxième chemin (32) commandé par le signal de commande (IB) pour la formation d'une deuxième durée de retard totale (T2) dépendante du signal de commande (IB) et est conçue pour calibrer le signal de commande (IB) de telle façon que la première durée de retard totale (T1) diffère de la deuxième durée de retard totale (T2) d'une valeur prédéfinie non nulle d'un multiple entier (K) de la durée de la période (TREF) du signal de référence (xREF).

**7.** Générateur de fréquence à boucle de phase selon la revendication 6, **caractérisé en ce que** l'unité de calibrage (28) est conçue pour calibrer le signal de commande (IB) de telle façon que la première durée de retard totale (T1) diffère de la deuxième durée de retard totale (T2) d'une durée de période (TREF) de (K=1).

**8.** Générateur de fréquence à boucle de phase selon la revendication 6 ou 7, **caractérisé en ce que** le premier chemin (31) pour la formation de la première durée de retard totale (T1) présente un premier oscillateur annulaire (36a) commandé par le signal de commande (IB) et **en ce que** le deuxième chemin (32) pour la formation de la deuxième durée de retard totale (T2) présente un deuxième oscillateur annulaire (36b) commandé par le signal de commande (IB), le premier chemin (31) et le deuxième chemin (32) étant conçus de telle façon que la première durée de retard totale (T1) diffère de la deuxième durée de retard totale (T2) de la valeur prédéfinie non nulle du multiple entier (K) de la durée de la période (TREF) lorsque le signal de commande (IB) est calibré.

**9.** Générateur de fréquence à boucle de phase selon la revendication 8, **caractérisé en ce que** le premier oscillateur annulaire (36a) et le deuxième oscillateur annulaire (36b) sont conformés sensiblement identiques.

**10.** Générateur de fréquence à boucle de phase selon la revendication 8 ou 9, **caractérisé en ce que** :

a) le premier oscillateur annulaire (36a) présente au moins une première unité de retard (41a) commandée par le signal de commande (IB) qui est conçue pour retarder un signal existant à son entrée d'une première valeur de durée ($\Delta$T1) dépendante du signal de commande (IB), correspondant à cette durée de retard ($\Delta$T>0) non nulle que l'unité de retard (26) connectable provoque lorsque le terme de commande (dT) prend une première valeur (dT1), et **en ce que**

b) le deuxième oscillateur annulaire (36b) présente au moins une deuxième unité de retard (41b) commandée par le signal de commande (IB) qui est conçue pour retarder un signal existant à son entrée d'une deuxième valeur de durée ($\Delta$T2) dépendante du signal de commande (IB), correspondant à cette durée de retard ($\Delta$T) que l'unité de retard (26) connectable provoque lorsque le terme de commande (dT) prend une deuxième valeur (dT2), la deuxième valeur de durée (ΔT2) étant plus longue que la première valeur de durée (ΔT1).

**11.** Générateur de fréquence à boucle de phase selon l'une quelconque des revendications 6 à 9, **caractérisé en ce que**

a) le premier chemin (31) pour la formation de la première durée de retard totale (T1) présente au moins une première unité de retard (41a) commandée par le signal de commande (IB) qui est conçue pour retarder un signal existant à son entrée d'une première valeur de durée (ΔT1) dépendante du signal de commande (IB), correspondant à cette durée de retard (ΔT>0) non nulle que l'unité de retard (26) connectable provoque lorsque le terme de commande (dT) prend une première valeur (dT1), et

b) le deuxième chemin (32) pour la formation de la deuxième durée de retard totale (T2) présente au moins une deuxième unité de retard (41b) commandée par le signal de commande (IB) qui est conçue pour retarder un signal existant à son entrée d'une deuxième valeur de durée (ΔT2) dépendante du signal de commande (IB), correspondant à cette durée de retard (ΔT) que l'unité de retard (26) connectable provoque lorsque le terme de commande (dT) prend une deuxième valeur (dT2), la deuxième valeur de durée (ΔT2) étant plus longue que la première valeur de durée (ΔT1).

**12.** Générateur de fréquence à boucle de phase selon la revendication 10 ou 11, **caractérisé en ce que** la(les) première (s) unité(s) de retard (41a), la(les) deuxième(s) unité(s) de retard (41b) et l'unité de retard connectable (26) sont conçues de manière sensiblement identique.

**13.** Générateur de fréquence à boucle de phase selon l'une quelconque des revendications 10 à 12, **caractérisé en ce que** la première valeur ou les premières valeurs (dT1) et la deuxième valeur ou les deuxièmes valeurs (dT2) sont choisies de telle manière que la première durée de retard totale (T1) diffère de la deuxième durée de retard totale (T2) de la valeur prédéfinie non nulle du multiple entier (K) de la durée d'une période (TREF) lorsque le signal de commande (IB) est calibré.

**14.** Générateur de fréquence à boucle de phase selon l'une quelconque des revendications 6 à 13, **caractérisé en ce que**

a) le premier chemin (31) est conçu pour fournir un premier signal de sortie (y1) présentant un premier flanc,
b) le deuxième chemin (32) est conçu pour fournir un deuxième signal de sortie (y2) présentant un deuxième flanc,
c) l'unité de calibrage (28) présente un circuit de détection de phase (33) conçu pour constater si le premier flanc précède ou suit le deuxième flanc et pour générer un terme d'un signal numérique (A) dont la valeur représente une valeur nécessaire, compte tenu de cette constatation, du signal de commande (IB).

**15.** Générateur de fréquence à boucle de phase selon l'une quelconque des revendications précédentes, dans lequel le signal de commande (IB) est conçu sous la forme d'un courant de commande.

**16.** Générateur de fréquence à boucle de phase selon l'une quelconque des revendications précédentes, **caractérisé en ce que** le générateur de fréquence à boucle de phase présente un mode de calibrage et est conçu pour approvisionner l'unité de calibrage (28) en énergie de fonctionnement que lorsque le mode de calibrage est activé.

**17.** Générateur de fréquence à boucle de phase selon l'une quelconque des revendications précédentes, **caractérisé en ce que** l'on prévoit une unité de commande (27) reliée à l'unité de retard (26) connectable conçue pour définir les termes de commande (dT).

**18.** Générateur de fréquence à boucle de phase selon la revendication 17, **caractérisé en ce que** l'unité de commande (27) présente un modulateur sigma delta (27a) et est conçue pour définir les termes de commande (dT) en fonction d'au moins un signal mis à disposition par le modulateur sigma delta.

**19.** Générateur de fréquence à boucle de phase selon la revendication 18, **caractérisé en ce que**:

a) le modulateur sigma delta (27a) présente un accumulateur conçu pour l'accumulation d'un signal d'entrée (FRAC) du modulateur sigma delta et pour la mise à disposition d'un signal accumulé (acc1), et
b) l'unité de commande (27) est conçue pour définir les termes de commande (dT) en fonction du signal accumulé (acc1).

**20.** Générateur de fréquence à boucle de phase selon la revendication 19, **caractérisé en ce que:**

a) l'unité de commande (27) présente un modulateur sigma delta (27a) du deuxième ordre ou plus, conçu pour fournir un premier signal de dépassement (cy) et un deuxième signal de dépassement (cy1),

b) l'unité de commande (27) est conçue pour définir les termes de commande (dT) en fonction du premier et du deuxième signal de dépassement (cy, cy1).

21. Générateur de fréquence à boucle de phase selon la revendication 20, **caractérisé en ce que** l'on prévoit un modulateur sigma delta (27a) de second ordre.

22. Dispositif émetteur/récepteur (11-13), plus particulièrement pour un système de transmission de données (10) selon la norme IEEE 802.15.4, comprenant une antenne (14) ainsi qu'une unité d'émission/réception (15) reliée à l'antenne pour l'émission et la réception de données, plus particulièrement selon la norme IEEE 802.15.4, comprenant un générateur de fréquence à boucle de phase (20) selon l'une quelconque des revendications 1 à 21.

23. Circuit intégré, plus particulièrement pour un dispositif émetteur/récepteur selon la revendication 22, comprenant un générateur de fréquence à boucle de phase (20) selon l'une quelconque des revendications 1 à 21.

FIG. 1

FIG. 2

FIG. 3

FIG. 4

**EP 1 798 858 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6064272 A
- EP 1434352 A

- WO 2004088846 A